(19) Europäisches Patentamt
European Patent Office
Office européen des brevets

(11) Veröffentlichungsnummer: **0 054 150**
**B1**

(12) # EUROPÄISCHE PATENTSCHRIFT

(45) Veröffentlichungstag der Patentschrift: **09.05.84**

(21) Anmeldenummer: **81108810.3**

(22) Anmeldetag: **23.10.81**

(51) Int. Cl.³: **G 03 C 1/70**, G 03 C 1/68, G 03 F 7/10, G 03 F 7/26, C 08 G 18/78

(54) **Photopolymerisierbares Aufzeichnungsmaterial und Verfahren zur Herstellung von Reliefformen mittels dieses Aufzeichnungsmaterials.**

(30) Priorität: **13.12.80 DE 3047026**

(43) Veröffentlichungstag der Anmeldung: **23.06.82 Patentblatt 82/25**

(45) Bekanntmachung des Hinweises auf die Patenterteilung: **09.05.84 Patentblatt 84/19**

(84) Benannte Vertragsstaaten: **BE CH DE FR GB IT LI NL**

(56) Entgegenhaltungen: **DE - A - 2 116 591**

(73) Patentinhaber: **BASF Aktiengesellschaft, Carl-Bosch-Strasse 38, D-6700 Ludwigshafen (DE)**

(72) Erfinder: **Lehner, August, Wachenheimerstrasse 13, D-6701 Roedersheim (DE)**
Erfinder: **Jun, Mong Jon, Dr., Maulbeerstueck 20, D-6720 Speyer (DE)**
Erfinder: **Lenz, Werner, Dr., Heinrich-Baermannstrasse 14, D-6702 Bad Duerkheim (DE)**
Erfinder: **Richter, Peter, Dr., Bensheimer Ring 24, D-6710 Frankenthal (DE)**
Erfinder: **Sanner, Axel, Dr., Lorscher Ring 2C, D-6710 Frankenthal (DE)**
Erfinder: **Schornick, Gunnar, Dr., Obergasse 48, D-6719 Hettenleidelheim (DE)**
Erfinder: **Werther, Heinz Ulrich, Dr., Hoffmannstrasse 12, D-6706 Wachenheim (DE)**
Erfinder: **Eckell, Albrecht, Dr., Paul-Klee-Strasse 2, D-6710 Frankenthal (DE)**

**EP 0 054 150 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein photopolymerisierbares Aufzeichnungsmaterial mit einer auf einem Schichtträger aufgebrachten photopolymerisierbaren Schicht, bei dem die photopolymerisierbare Schicht neben einer photopolymerisierbaren, ethylenisch ungesättigten Verbindung, einem Photopolymerisationsinitiator sowie gegebenenfalls sonstigen üblichen Zusatzstoffen als Bindemittel ein Polyurethan mit Doppelbindungen, die der Photopolymerisation zugänglich sind, enthält. Die Erfindung betrifft desweiteren Verfahren zur Herstellung von Reliefformen, wie z.B. Druckplatten und Photoresists, mittels dieses photopolymerisierbaren Aufzeichnungsmaterials.

Es ist bekannt, Reliefdruckplatten oder Photoresists auf photochemischem Wege herzustellen, indem man eine auf einem Schichtträger aufgebrachte photopolymerisierbare Schicht bildweise mittels einer Strahlungsquelle, insbesondere aktinischem Licht, belichtet und die belichtete Photoschicht durch Behandeln mit einem Lösungsmittel entwickelt, in welchem die unbelichteten, nicht aber die belichteten Bereiche der Photoschicht löslich oder zumindest dispergierbar sind. Die photopolymerisierbare Schicht dieser Aufzeichnungsmaterialien enthält dabei im allgemeinen niedermolekulare photopolymerisierbare Verbindungen, Photoinitiatoren sowie ein polymeres Bindemittel, welches auch der Photopolymerisation oder Photovernetzung zugänglich sein kann. Die Anforderungen, die an solche photopolymerisierbare Aufzeichnungsmaterialien und insbesondere auch an das polymere Bindemittel der photopolymerisierbaren Schicht gestellt werden, sind aus der einschlägigen Literatur bekannt. Es ist dabei heutzutage erstrebenswert, photopolymerisierbare Aufzeichnungsmaterialien zu schaffen, die nicht nur hinreichende mechanische und drucktechnische Eigenschaften besitzen, sondern darüber hinaus in umwelt- und arbeitsfreundlichen Lösungsmitteln entwickelbar sind.

Photopolymerisierbare Aufzeichnungsmaterialien, die als Bindemittel in der photopolymerisierbaren Schicht ein Polyurethan enthalten, haben sich in mancher Hinsicht, insbesondere für den Druck mit Ölfarben als vorteilhaft erweisen. So sind bereits vielfach für die Herstellung von Druckplatten geeignete photopolymerisierbare Gemische beschrieben, die neben einem Photoinitiator und gegebenenfalls anderen photopolymerisierbaren Verbindungen ein Polyurethan oder ein Polyurethan-Präpolymerisat mit Acrylatdoppelbindungen am Ende der Polyurethankette enthalten (vgl. z.B. DE-A- 21 15 373, DE-A- 24 27 494, DE-A- 26 07 257, US-A 4 078 015, DE-A- 26 41 189, DE-A- 29 17 748). Bei Einsatz von bestimmten Polyetherurethanen mit endständigen Acrylatdoppelbindungen können so auch schon photopolymerisierbare Gemische erhalten werden, die mit Wasser oder wässrig-alkalischen Medien entwickelbar sind (vgl. DE-A- 21 15 373, DE-A- 26 07 259, DE-A- 29 17 748). Während in der DE-A- 26 41 189 und DE-A 29 17 748 der Einsatz von niedermolekularen flüssigen Polyetherurethanen mit endständigen Acrylatdoppelbindungen beschrieben wird, sollen gemäss der DE-A 21 15 373, DE-A 24 27 494 oder US-A- 4 078 015 niedermolekulare Polyurethane mit endständigen Acrylat-Doppelbindungen eingesetzt werden, die bei Raumtemperatur zwar fest und trocken sind, bei erhöhter Temperatur jedoch niedrig-viskose Flüssigkeiten bilden.

Diese bekannten photopolymerisierbaren Gemische auf Basis von Polyurethanen mit endständigen Acrylatdoppelbindungen haben jedoch den Nachteil, dass die Polyurethane zur Erzielung des für die Härtung durch Photopolymerisation notwendigen hohen Doppelbindungsanteils im photopolymerisierbaren Gemisch recht niedermolekular sind und die photopolymerisierbaren Gemische daher nicht allen gewünschten mechanischen Anforderungen genügen.

Aus der US-A- 3 658 531 und der DE-A- 23 00 371 ist es bekannt, für die Herstellung von flexiblen Druckplatten photopolymerisierbare Materialien einzusetzen, die als Basiskomponente Polyurethan-Elastomere mit seitenständigen Vinyl-Gruppen enthalten. Im Vergleich zu den niedermolekularen Polyurethanen mit endständigen Acrylat-Doppelbindungen zeichnen sich die gemäss der US-A- 3 658 531 und DE-A- 23 00 371 einzusetzenden Polyurethane mit seitenständigen Vinylgruppen dadurch aus, dass die Anzahl der polymerisierbaren ungesättigten Gruppen im Polyurethan-Molekül bei gegebenem Molekulargewicht variiert werden kann, wodurch es möglich wird, höhermolekulare Produkte zum Einsatz zu bringen und dennoch eine hinreichend hohe Anzahl von Doppelbindungen für die Photopolymerisation zu haben. Dabei kann es vorteilhaft sein, wenn man den photopolymerisierbaren Gemischen spezielle Polymerisationsbeschleuniger, wie z.B. tertiäre Amine, beimischt (vgl. DE-A- 23 00 371). Ein Nacheil der in der US-A- 3 658 531 und DE-A- 23 00 371 beschriebenen Verfahren für die Herstellung von flexiblen Druckplatten liegt darin, dass diese Platten nach dem Belichten nur mit Lösungsmitteln oder Lösungsmittel-Gemischen, z.B. Methylethylketon oder Dimethylformamid , ausgewaschen und entwickelt werden können, die sehr wenig umwelt- und arbeitsfreundlich sind.

Schliesslich sind bereits Polyurethane bekannt, die tertiäre Stickstoff-Gruppierungen eingebaut enthalten. So werden in der DE-A-27 39 378 wasserlösliche bzw. wasserdispergierbare Oligo- und Polyurethane mit teriären bzw. quaternären Stickstofatomen für den Einsatz als Leder- und Textilhilfsmittel, als Haftvermittler oder zur Herstellung von Magnetaufzeichnungsträgern beschrieben. In der DE-A- 21 40 306 wird die Lehre erteilt, zur Herabsetzung der Inhibierung der Photopolymerisation durch Luftsauerstoff in photopolymerisierbaren Gemischen auf Polyurethan-Basis solche Polyurethane einzusetzen, die sekundäre oder tertiäre Aminogruppen oder Harnstoffgruppen eingebaut enthalten. Ausweislich den Beispielen der DE-A- 21 40 306 werden dabei, sofern die Verwendung lichtempfindlicher Gemische für die Herstellung von Druckplatten angesprochen ist, ausschliesslich Polyurethane mit endständigen Acrylat-Doppelbindungen, wie sie in den zuvor genannten Druckschriften beschrieben sind, eingesetzt. Auch diese Produkte und die daraus hergestellten photopolymerisierbaren Aufzeichnungsmaterialien und Druckplatten besitzen somit nicht das gewünschte und angestrebte Eigenschaftsbild, insbesondere für den flexographischen Anwendungsbereich.

Aufgabe der vorliegenden Erfindung ist es, ein photopolymerisierbares Aufzeichnungsmaterial mit einer photopolymerisierbaren Schicht auf Polyurethan-Basis aufzuzeigen, das die Nachteile der aus dem Stand der Technik bekannten Aufzeichnungsmaterialien dieser Art nicht oder nur in erheblich geringerem Umfang aufweist. Insbesondere soll das photopolymerisierbare Aufzeichnungsmaterial leicht herstellbar, bereits vor der Blichtung leicht handhabbar und verarbeitbar sein, möglichst geringe Neigung zum Kaltfluss und insbesondere zum Verspröden besitzen sowie im Vergleich zu den bisher bekannten Materialien dieser Art eine herabgesetzte Haut- und Kontaktgiftigkeit haben. Das Aufzeichnungsmaterial soll sich zur Herstellung von Reliefdruckplatten, insbesondere weichelastomeren Reliefdruckplatten eignen, dementsprechend gute Belichtungseigenschaften und hohes Auflösungsvermögen sowie nach der Belichtung und Entwicklung gute Druckeigenschaften bei gleichzeitig hoher Wiederverwendbarkeit besitzen. Die Entwicklung des belichteten Aufzeichnungsmaterials soll in umwelt- und arbeitsfreundlichen Lösungsmitteln, insbesondere in Wasser oder wässrigen Medien, durchgeführt werden können.

Es wurde überraschenderweise gefunden, dass diese Aufgabe gelöst wird, wenn das photopolymerisierbare Aufzeichnungsmaterial in der photopolymerisierbaren Schicht als Bindemittel ein im wesentlichen lineares, bei Raumtemperatur festes, hochmolekulares thermoplasitsches Polyurethan enthält, das seitenständige photopolymerisierbare Doppelbindungen und quaternäre und/oder quaternisierbare Stickstoff-Atome eingebaut enthält.

Gegenstand der vorliegenden Erfindung ist demzufolge ein photopolymerisierbares Aufzeichnungsmaterial mit einem Schichtträger A, einer damit direkt oder indirekt haftfest verbundenen photopolymerisierbaren Schicht B sowie gegebenenfalls einer Deckschicht und/oder Deckfolie C, bei dem die photopolymerisierbare Schicht B

1. als polymeres Bindemittel ein in einem Lösungsmittel lösliches Polyurethan mit photopolymerisierbaren Doppelbindungen,
2. mindestens eine weitere photopolymerisierbare, ethylenisch ungesättigte Verbindung,
3. einen Photopolymerisationsinitiator sowie
4. gegebenenfalls sonstige übliche Zusatzstoffe

enthält, welches dadruch gekennzeichnet ist, dass in der photopolymerisierbaren Schicht B als Bindemittel (Komponente B1) ein im wesentlichen lineares, bei Raumtemperatur festes, hochmolekulares, thermoplastisches Polyurethan enthalten ist, das seitenständige photopolymerisierbare Doppelbindungen und quaternäre und/oder quaternisierbare Stickstoff-Atome eingebaut enthält.

Gegenstand der Erfindung sind weiterhin spezielle Ausgestaltungsformen dieses photopolymerisierbaren Aufzeichnungsmateriales gemäss der nachfolgenden detaillierten Beschreibung. Gegenstand der Erfindung sind ferner Verfahren zur Herstellung von Reliefformen, wie z.B. von ölfesten Reliefdruckplatten, insbesondere ölfesten weichelastomeren Reliefdruckplatten, oder von Photoresists, mittels des photopolymerisierbaren Aufzeichnungensmaterials.

Es war überraschend, dass bei Einsatz der erfindungsgemässen Polyurethane als Bindemittel photopolymerisierbare Aufzeichnungsmaterialien mit insgesamt sehr guten Eigenschaften und einer Reihe besonderer Vorteile erhalten werden, die für die Herstellung von Reliefdruckplatten oder Photoresists geeignet sind. So besitzen die Polyurethane bereits im Grundzustand eine hohe Reisskraft, gute Dehnungs- und Biegeeigenschaften sowie Elastizität, so dass die Aufzeichnungsmaterialien bereits vor der Belichtung ein hohes mechanisches Niveau aufweisen und sich die von der Anwendung her geforderten Eigenschaften der belichteten Materialien, wie z.B. Elastizität und Härte, in dem gewünschten Rahmen einstellen lassen, ohne dass hierfür andere Nachteile, wie beispielsweise schlechte Belichtungseigenschaften, Verspröden oder geringe Alterungsbeständigkeit, in Kauf genommen werden müssen. Die Entwicklung der belichteten Materialien lässt sich in Wasser oder wässrigen Medien durchführen. Wegen des hohen Auflösevermögens der erfindungemässen Aufzeichnungsmaterialien geben die daraus hergestellten Reliefdruckplatten eine exakte Tonwertübertragung, wodurch sie besonders für die Wiedergabe von Halbtoneffekten günstig sind. Aufgrund ihrer mechanischen Eigenschaften und insbesondere der guten Abriebsfestigkeit besitzen diese Platten eine hohe Wiederverwendbarkeit, wobei auch die guten Farbaufnahme- und -abgabeeigenschaften von besonderem Vorteil sind.

Die in den erfindungsgemässen photopolymerisierbaren Aufzeichnungsmaterialien als Komponente B1 einzusetzenden Polyurethane sind im wesentlichen linear und bei Raumtemperatur fest und im allgemeinen nicht klebrig. Zur Erzielung möglichst günstiger mechanischer und verarbeitungstechnischer Eigenschaften soll ihr Erweichungspunkt vorteilhaft über 35°C, vorzugsweise über 55°C und insbesondere über 70°C liegen. Die erfindungsgemäss einzusetzenden thermoplastischen Polyurethane (B1) sollen dabei hochmolekular sein und weisen im allgemeinen K-Werte [nach Finkentscher, Cellulosechemie 13, 58

(1932)] zwischen 25 und 75 auf. Vorzugsweise liegen die K-Werte im Bereich von etwa 30 bis 60.

Die erfindungsgemäss einzusetzenden Polyurethane (B1) sollen darüber hinaus quaternäre und/oder quaternisierbare Stickstoffatome sowie seitenständige, der Photopolymerisation zugängliche Doppelbindungen eingebaut enthalten. Bei den quaternisierbaren Stickstoffatomen handelt es sich insbesondere um tertiäre Stickstoffatome, die in an und für sich bekannter Weise durch übliche Protonierungsmittel, wie z.B. anorganische und organische Säuren, oder Quaternierungsmittel, wie beispielsweise Alkylhalogenide, in den quaternären Ammoniumstickstoff überführt werden können. Es hat sich als vorteilhaft, jedoch nicht unbedingt notwendig erwiesen, wenn die Quaternisierung der Polyurethane bereits vor der Herstellung der photopolymerisierbaren Schicht (B) erfolgt, wobei die Quaternisierung möglichst vollständig sein soll, aber auch nur teilweise in an sich bekannter Weise durchgeführt werden kann. Es ist jedoch ebenso möglich, für die Herstellung der Aufzeichnungsmaterialien von Polyurethanen auszugehen, die nur quaternisierbare Stickstoffatome eingebaut enthalten, die dann nach der Belichtung bei der Entwicklung der bildmässig belichteten photopolymeren Schicht durch das für die Entwicklung eingesetzte Auswaschmittel quaternisiert werden können, wodurch die Auswaschgeschwindigkeit erhöht werden kann. Es hat sich gezeigt, dass die quaternären und/oder quaternisierbaren Stickstoffatome im Polyurethan (B1) nicht nur auf die Reaktivität bei der Belichtung einen Einfluss haben, sondern dass sie auch für die sonstigen Eigenschaften des erfindungsgemässen photopolymerisierbaren Aufzeichnungsmaterials von Bedeutung sind. Die Polyurethane enthalten dabei etwa von 0,2 bis 2,5 Gew.% an quaternisierbaren und/oder quaternären Stickstoffatomen, bezogen auf das Gewicht des Polyurethans. Ausserhalb dieser Grenzen sind Produkteigenschaften, wie beispielsweise die Auswaschbarkeit in Wasser oder wässrigen Medien oder die Elastizität, stark verschlechtert. Der Gehalt an quaternären und/oder quaternisierbaren Stickstoffatomen im Polyurehan (B1) richtet sich auch nach der Art des Polyurethans, wobei sich im allgemeinen als vorteilhaft erwiesen hat, wenn das Polyurehtan mindestens 0,4 Gew.% und höchstens 1,8 Gew.%, vorzugsweise zwischen 0,6 und 1,2 Gew.% an quaternären und/oder quaternisierbaren Stickstoffatomen, bezogen auf das Gewicht des Polyurethans, eingebaut enthält.

Die in den erfindungsgemäss einzusetzenden Polyurethanen (B1) enthaltenen Doppelbindungen können grundsätzlich jeder beliebigen Art sein, sofern sie seitenständig zur Polyurethan-Hautpkette eingebaut und zur Teilnahme an der Photopolymerisation befähigt sind. Der Ausdruck «seitenständig zur Polyurethan-Hauptkette eingebaute Doppelbindungen» umfasst dabei nicht nur Doppelbindungen, die in einer einfach an die Polyurethan-Hauptkette gebundenen Seitenkette mit freiem Kettenende enthalten sind, sondern auch solche, die in einer doppelt an die Polyurethan-Hauptkette gebundenen Seitengruppe stehen. Es handelt sich hierbei in der Regel um Kohlenstoff-Kohlenstoff-Doppelbindungen, die in Seitengruppen mit freien Kettenenden vorteilhafterweise endständig stehen, insbesondere um acrylische Doppelbindungen oder ähnliche. Der Gehalt an den seitenständigen, photopolymerisierbaren Doppelbindungen in dem Polyurethan (B1) beträgt 0,01 bis 2,5 Gew.%, bezogen auf das Gewicht des Polyurethans. Der Anteil der seitenständigen photopolymerisierbaren Doppelbindungen im Polyurethan (B1) richtet sich dabei sowohl nach der Reaktivität der Doppelbindungen als auch nach dem angestrebten Vernetzungsgrad nach der Belichtung und damit zusammenhängend nach dem gewünschten Eigenschaftsbild des Aufzeichnungsmaterials. Es hat sich als vorteilhaft herausgestellt, wenn das Polyurethan (B1) mindestens 0,05 Gew.%, insbesondere mindestens 0,2 Gew.%, an eingebauten seitenständigen, photopolymerisierbaren Doppelbindungen, bezogen auf das Gewicht des Polyurethans, enthält. Je nach Art und Vewendungszweck des photopolymerisierbaren Aufzeichnungsmaterials ist es günstig, wenn der Gehalt an eingebauten seitenständigen, photopolymerisierbaren Doppelbindungen im Polyurethan (B1) nicht über 2 Gew.%, vorteilhaft nicht über 1,8 Gew.%, bezogen auf das Gewicht des Polyurethans, liegt. Das Gewicht einer Kohlenstoff-Kohlenstoff-Doppelbindung wird dabei mit 24 gerechnet.

Die in der photopolymerisierbaren Schicht B erfindungsgemäss als Bindemittel einzusetzenden Polyurethane (B1) können in an sich üblicher Weise durch Umsetzung von Diisocyanaten, Polydiolen, geeigneten olefinisch ungesättigten Verbindungen mit zwei im Sinne der Isocyanatchemie reaktionsfähigen Wasserstoffatomen, im Sinne der Isocyanatchemie bifunktionell reaktionsfähigen tertiären Stickstoff-Verbindungen sowie gegebenenfalls weiteren, für die Herstellung von Polyurethanen üblichen niedermolekularen Diolen, Diaminen oder Aminoalkoholen als Kettenverlängerer hergestellt werden. Zu den Aufbaukomponenten der erfindungsgemäss einzusetzenden Polyurethane (B1) ist im einzelnen folgendes auszuführen:

Als Diisocyanate, die allein oder im Gemisch miteinander eingesetzt werden können, eignen sich die üblichen, aus der Polyurethanchemie bekannten Verbindungen. Es kommen dabei im Prinzip beliebige aliphatische, cycloaliphatische, araliphatische, aromatische und heterocyclische Diisocyante in Betracht. Beispielhaft seien genannt 4,4'-Diphenylmethandiisocyanat, Dicyclohexylmethandiisocyanat, 1,5-Napthylendiisocyanat, 2,4- und 2,6-Toluylendiisocyanat, Hexamethylendiisocyanat, Isophorondiisocyanat und Trimethylhexamethylendiisocyanat. Weitere geeignete Diisocyanate sind u.a. 4,4'-Dibenzyldiisocyanat, 1,3- und 1,4-Phenyldiisocyanat, Cyclohexan-1,4-diisocyanat, Xylylendiisocyanate, halogenierte Diisocyanate, wie z.B. 4-Chlor-1,3-phenyldiisocyanat, sowie die Hydrierungsprodukte von aromatischen Diisocyanatverbindungen, wie z.B. 1,5-Tetrahydronaphthylendiisocyanat. Die Diisocyanate werden bei der Herstellung der erfindungsgemäss zu verwendenden Polyurethane (B1) in solchen Mengen eingesetzt dass ihr Gehalt im Polyurethan zwischen 20 und 50 Gew.%, insbesondere im Bereich von etwa 25 bis 45 Gew.%, bezogen auf das Polyurethan, liegt.

Als Polydiole für den Aufbau der erfindungsgemäss einzusetzenden Polyurethane (B1) eignen sich die im wesentlichen linearen bekannten Polyesterdiole, Polyetherdiole, Polylacton- sowie Polycarbonatdiole. Ausser den endständigen Hydroxylgruppen können die Polydiole gegebenenfalls in geringerem Umfang auch noch Carboxyl-, Amino- oder Mercaptogruppen enthalten. Das Molekulargewicht der Polydiole liegt vorteilhafterweise zwischen 400 und 5000, vorzugsweise zwischen etwa 500 und 4000. Die Polydiole werden bei der Herstellung der erfindungsgemäss einzusetzenden Polyurethane (B1) in solchen Mengen verwendet, dass ihr Anteil im Polyurethan von etwa 15 bis 65 Gew.%, insbesondere von etwa 20 bis 55 Gew.%, bezogen auf das Polyurethan, beträgt. Für die Herstellung der Polyurethane können die Polydiole alleine oder im Gemisch miteinander verwendet werden.

Geeignete Polyesterdiole sind insbesondere die gesättigten Polyesterdiole, wie z.B. Veresterungspordukte von Dicarbonsäuren, insbesondere Adipinsäure, mit $C_2$- bis $C_{10}$-Alkandiolen oder Oxalkandiolen mit 2 bis 6 Kohlenstoffatomen. Beispielhaft seien als Polyesterdiole genannt Adipate mit Glykol (Molekulargewicht etwa 2000), mit Diethylenglykol (Molekulargewicht ca. 2000), mit Butandiol-1,4 (Molekulargewicht 940), mit Hexandiol-1,6 (Molekulargewicht 1000), mit einem Hexandiol-1,6/Butandiol-1,4-Gemisch im Verhältnis 1:1 (Molekulargewicht 1000 bzw. 2000) und 2,2-Dimethylpropandiol-1,3 (Molekulargewicht 1000). Geeignete Polycarbonatdiole sind z.B. Hecandiolpolycarbonate. Für die Polylactondiole seien stellvertretend die Polycaprolactondiole (Molekulargewicht 830 und 2000) genannt. Günstig sind insbesondere die Polyetherdiole. Als Beispiele dafür seien genannt die Polymerisationsprodukte des Ethylenoxids, Propylenoxids, Tetrahydrofurans, Buthylenoxids oder deren Misch- oder Pfropfpolymerisationsprodukte sowie die durch Kondensation von mehrwertigen Alkoholen oder Mischungen derselben gewonnenen Kondensate oder die durch Alkoxylierung von mehrwertigen Alkoholen gewonnenen Produkte. Besonders vorteihaft sind z.B. Polytetrahydrofuran, Polyethylenglykol, Polypropylenglykol oder Ethylenoxid/Propylenoxid-Mischpolykondensationsprodukte, wobei der Propylenoxid-Anteil vorzugsweise 10 bis 90 Gew.% beträgt. Bevorzugt werden für die Herstellung der Polyurethane (B1) solche Polydiole eingesetzt oder zumindest mitverwendet, die mindestens 5 Ätherbindungen enthalten.

Die quaternisierbaren Stickstoffatome lassen sich in die erfindungsgemäss einzusetzenden Polyurethane (B1) einbauen, indem man bei deren Herstellung tertiäre Stickstoffatome tragende Verbindungen mitverwendet, die im Sinne der Isocyanatchemie im allgemeinen bifunktionell reaktionsfähig sein sollen. Als solche eignen sich insbesondere Diole mit tertiären Stickstoffatomen, aber auch z.B. entsprechende Diamine oder Aminoalkohole. Neben den bifunktionellen tertiären Stickstoff-Verbindungen können bei der Herstellung der Polyurethane (B1) in geringem Umfang jedoch beispielsweise auch tertiäre Stickstoffatome tragende Verbindungen mitverwendet werden, die im Sinne der Isocyanatchemie nur monofunktionell reaktionsfähig sind. Die Mitverwendung von höherfunktionellen, beispielsweise trifunktionellen tertiären Stickstoffverbindungen, ist weniger empfehlenswert, da hierdurch leicht zu stark verzweigte Polyurethane gebildet werden.

Als im Sinne der Isocyanatchemie bifunktionell reaktionsfähige tertiäre Stickstoff-Verbindungen werden vorteilhaft entsprechende niedermolekulare, als Kettenverlängerer wirkende Verbindungen eingesetzt. Hierbei kommen insbesondere Verbindungen der allgemeinen Formeln (I), (II) und (III)

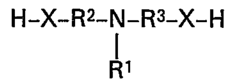
(I)

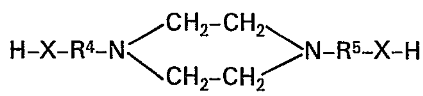
(II)

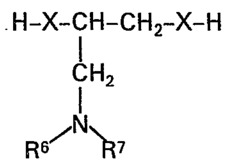
(III)

in Betracht, worin bedeuten:

X ein Sauerstoffatom, Schwefelatom oder eine -NR-Gruppe mit R = Wasserstoffatom oder einer niederen Alkylgruppe, insbesondere mit 1 bis 6 Kohlenstoffatomen;

$R^1$ eine Alkylgruppe, insbesondere mit 1 bis 6 Kohlenstoffatomen, eine Cycloalkyl- oder Aryl-Gruppe;

$R^2$-$R^5$ eine geradkettige oder verzweigte Alkylen- oder Oxalkylengruppe, insbesondere mit 1 bis 6 Kohlenstoffatomen, oder eine Cycloalkylen- oder Phenylen-Gruppe, wobei die Reste $R^2$ und $R^3$ bzw. $R^4$ und $R^5$ jeweils gleich oder verschieden sein können;

$R^6$, $R^7$ jeweils für sich eine Alkylengruppe, insbesondere mit 1 bis 6 Kohlenstoffatomen, eine Cycloalkylengruppe oder eine Arylgruppe oder $R^6$ und $R^7$ zusammen einen gegebenenfalls weitere Heteroatome enthaltenden Ring.

In den Formeln (I) und (II) ist X vorzugsweise ein Sauerstoffatom oder eine -NR-Gruppe, wobei

R insbesondere eine niedere Alkylgruppe, wie z.B. eine Methyl-, Ethyl- oder Propyl-Gruppe ist. $R^1$ stellt beispielsweise eine Methyl-, Ethyl-, Propyl-, Isopropyl-, Butyl- oder Isobutyl-Gruppe dar, vorzugsweise jedoch eine Methyl- oder Ethyl-Gruppe, oder einen Cyclohexyl- oder Phenylrest. Beispiele für die Gruppen $R^2$ bis $R^5$ sind die $-CH_2-$Gruppe, $-CH_2-CH_2-$Gruppe, die $CH_2-CH_2-CH_2-$Gruppe, die $-CH(CH_3)-CH_2-$Gruppe, die $-(CH_2)_4-$Gruppe; die $-(CH_2-CH_2-O)_n-CH_2-CH_2-$Gruppe, die $-[CH(CH_3)-CH_2-O]_n-CH(CH_3)-CH_2-$Gruppe mit n = einer ganzen Zahl, insbesondere 1 oder 2; die $C_6H_{10}$-Gruppe oder die $C_6H_4$-Gruppe.

In der Formel (III) ist X vorzugsweise ein Sauerstoffatom. $R^6$ und $R^7$ stellen, jeweils für sich, insbesondere eine niedere Alkylgruppe, wie z.B. die Methyl-, Ethyl- oder Propyl-Gruppe, oder einen Cyclohexylrest dar. $R^6$ und $R^7$ können zusammen auch einen vorzugsweise fünf- oder sechs-gliedrigen Ring bilden, der als weitere Heteroatome insbesondere N oder O enthalten kann, wie z.B. einen Piperidin-Ring, einen Piperazin-Ring oder einen Morpholin-Ring.

Im einzelnen seien als tertiäre Stickstoff-Verbindungen des Typs der allgemeinen Formeln (I) und (II) genannt N-Methyldiethanolamin, N-Ethyldiethanolamin, N-Methyldiisopropanolamin, N-Ethyldiisopropanolamin, N-Propyldiethanolamin, N-Propyldiisopropanolamin, N-Isopropyldipropanolamin, N-Isopropyldiethanolamin, N,N-Bis(2-hydroxyethyl)cyclohexylamin, N,N-Bis-(2-hydroxyethyl)anilin, N,N-Bis(2-hydroxyethyl)-toluidin; N,N'-Bis(hydroxymethyl)piperazin, N,N'-Bis(hydroxymethyl)-methylpiperazin, N,N'-Bis(2-hydroxyethyl)piperazin, N,N'-Bis(2-hydroxyethyl)-2,5-dimethylpiperazin, N,N'-Bis-(2-hydroxypropyl)-piperazin, N,N'-Bis(2-hydroxy-2-methylpropyl)piperazin, N,N'-Bis(hydroxylcyclohexyl)piperazin, N,N'-Bis(-hydroxy-cycloheptyl)piperazin, N,N'-Bis(hydroxyphenyl)piperazin, N,N'-Bis(-triethoxy)piperazin, N,N'-Bis-(dipropoxy)piperazin. Günstig ist auch der Einsatz von entsprechenden Diaminverbindungen, oder Aminoalkoholen, wie sie beispielsweise in der DE-A-24 54 676 angeführt sind. Stellvertretend für die Verbindungen des Typs der allgemeinen Formel (III) seien genannt 1-(N,N-Diethyl)aminopropandiol-2,3; 1-[N,N-Di-(n-propyl)]aminopropandiol-2,3; N-Morpholinopropandiol-2,3; N-Methyl-N'-piperazinpropandiol-2,3.

Die seitenständigen, photopolymerisierbaren Doppelbindungen können in das erfindungsgemäss einzusetzende Polyurethan (B1) eingeführt werden, indem man bei dessen Herstellung kettenverlängernde Verbindungen mitverwendet, die seitenständige olefinische Doppelbindungen aufweisen. Hierbei kann es sich um einfache, nicht aktivierte Doppelbindungen handeln, wie beispielsweise die Vinyl-Gruppe; besonders günstig sind aktivierte Doppelbindungen, wie beispielsweise acrylische Doppelbindungen. Vorzugsweise sind die Doppelbindungen in der Seitengruppe endständig.

Als Beispiele für kettenverlängernde Verbindungen mit nicht aktivierten Doppelbindungen seien Buten-1-diol-3,4,Dimethylolnorbonen und 4,5-Dimethylol-cyclohexen genannt. Als geeignete kettenverlängernde Verbindungen mit aktivierten Doppelbindungen kommen z.B. ungesättigte Carbonsäureesterdiole in Betracht. Hierbei kann es sich beispielsweise um Reaktionsprodukte von Dicarbonsäuren mit polymerisierbaren, olefinisch ungesättigten Glycidverbindungen handeln. Solche Verbindungen sind z.B. in der DE-A-21 64 386 beschrieben. Es kommen jedoch in gleicher Weise auch die Reaktionsprodukte von Epoxidverbindungen mit polymerisierbaren, olefinisch ungesättigten Carbonsäuren in Betracht. Als besonders vorteilhaft haben sich Reaktionsprodukte von Epoxiden mit α-β-ungesättigten Monocarbonsäuren, insbesondere Acryl- und/oder Methacrylsäure, erwiesen. Bei den Epoxiden kann es sich um OH-Gruppen tragende Monoepoxide, wie z.B. Glycidol, handeln; es können aber auch Epoxide mit zwei endständigen Epoxidgruppen sein. Insbesondere bevorzugt sind dabei die Reaktionsprodukte von Acryl- und/oder Methacrylsäure mit Diepoxiden entsprechend der allgemeinen Formel (IV)

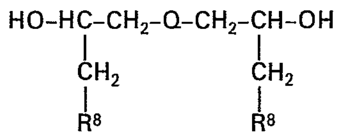

(IV)

worin bedeuten:

$R^8$ eine $(CH_2=CR^9-CO-O-)$-Gruppe mit $R^9$ = einem Wasserstoffatom oder einem Methyl-Rest,

Q $-O-$; $-O-(CH_2)_m-O$; $-O-(CH_2-CH_2-O-)_n$; $-O-(CHCH_3-CH_2-O-)_p$ mit m, und p unabhängigen ganzen Zahlen von 1 bis 10, vorzugsweise von 1 bis 7; oder ein Rest der allgemeinen Formel (V)

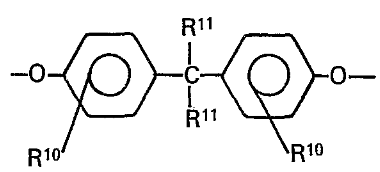

(V)

worin stehen

$R^{10}$ und

$R^{11}$ für ein Wasserstoffatom oder eine Alkyl-Gruppe mit 1 bis 10 Kohlenstoffatomen, z.B. die Methyl-, Ethyl-, Propyl-, Butyl- oder Hexyl-Gruppe.

Die Umsetzung zwischen den Epoxidverbindungen und den polymerisierbaren olefinisch ungesättigten Carbonsäuren ist eine ringöffnende Veresterung zwischen den Epoxidgruppen der Diepoxyverbindungen und den Carboxylgruppen der Carbonsäuren, die etwa analog der DE-A-21 64 386 in bekannter Weise ausgeführt werden kann (vgl. auch US-A-3 373 075 und US-A-2 824 851). Die vorgenannten Epoxidverbindungen und deren Umsetzungsprodukte können allein oder im Gemisch miteinander verwendet werden. Bevorzugt eignen sich für den Zweck der Erfindung Umsetzungsprodukte aus Bisphenol-A-Diglycidylether (z.B. ®Epikote 828 der Fa. Shell) oder 2,3-Epoxpropanol-1(Glycidol) mit Acryl- und/oder Methacrylsäure.

Die ungesättigten Carbonsäureesterdiole, insbesondere die Reaktionsprodukte von Acryl- und/oder Methacrylsäure mit Epoxidverbindungen, haben ein Molekulargewicht zwischen 146 und 3000.

Die kettenverlängernden Verbindungen mit seitenständigen olefinischen Doppelbindungen sollten für die spätere Umsetzung mit den Diisocyanaten im wesentlichen bifunktionell sein. ist die Funktionalität gegenüber Isocyanatgruppen grösser als 2 erfolgt gegebenenfalls eine zu starke Verzweigung des Polyurethan-Moleküls bzw. besteht die Gefahr einer Vernetzung.

Neben den genannten Verbindungen können bei der Herstellung der erfindungsgemäss einzusetzenden Polyurethane (B1) weitere niedermolekulare Diole, Diamine oder Aminoalkohole mit Molekulargewichten zwischen 61 und 400 als Kettenverlängerungsmittel eingesetzt werden. Der Einsatz solcher zusätzlichen Kettenverlängerungsmittel hängt einerseits ab von den gewählten Ausgangsverbindungen und dem gewünschten Molekulargewicht, andererseits aber auch von den angestrebten Eigenschaften des Polyurethans und des Aufzeichnungsmaterials. So führen beispielsweise Harnstoff-Gruppen im Polyurethan, wie sie z.B. bei Einsatz von Diaminen oder Aminoalkoholen als Kettenverlängerer gebildet werden, zu härteren Produkten. Als Kettenverlängerer können eingesetzt werden die üblichen gesättigten oder ungesättigten Glykole, wie Ethylenglykol und Kondensate des Ethylenglykols, Butandiol, Propandiol-1,2, Propandiol-1,3, Neopentyl-glykol, Hexandiol-1,6, Decandiol-1,10, Dioxethoxyhydrochinon, Butendiol; alkoxylierte aliphatische, cycloaliphatische, aromatische oder heterocyclische primäre und sekundäre Amine, wie beispielsweise Ethanolamin, N-Methyl-ethanolamin, N-Butylethanolamin, N-Oleylethanolamin, N-Cyclohexylisopropanolamin, polyethoxyliertes N-Butyl-ethanolamin; die aliphatischen, cycloaliphatischen oder aromatischen Diamine, wie Ethylendiamin, Hexamethylendiamin, Piperazin, 1,4-Cyclohexylen-diamin, Benzidin, Diamindiphenylmethan, 3,3'-Dimethyl-4,4'-diaminodicyclohexylmethan, die Isomeren des Phenylendiamins oder Hydrazins.

Die Herstellung der Polyurethane kann unter den aus der Literatur bekannten üblichen Bedingungen der Polyaddition in Masse oder in Lösung erfolgen. Die einzelnen Komponenten werden dabei im allgemeinen in einem solchen Verhältnis zueinander eingesetzt, dass das NCO/OH, NH-Molverhältnis etwa 0,8 bis 1,85, insbesondere etwa 0,9 bis 1,2, beträgt.

Zweckmässigerweise erfolgt die Herstellung der Polyurethane in Lösung. Dabei kann jedes beliebige Lösungsmittel eingesetzt werden, das mit der Polyurethanmasse und den Reaktionspartnern nicht in Reaktion tritt. Bevorzugte Lösungsmittel sind gegebenenfalls halogenierte Kohlenwasserstoffe, Ketone, Ether, Ester oder Nitrile, wie z.B. Aceton, Methylethylketon, Acetonitril, Ethylacetat, Methylenchlorid, Chloroform, Tetrachlorkohlenstoff, Dimethylformamid, Dimethylsulfoxid, Tetrahydrofuran, Dioxan oder t-Butanol. Selbstverständlich können auch Mischungen derartiger Lösungsmittel verwendet werden. Für die Herstellung der Polyurethane in Lösung bieten sich die bekannten und üblichen Ein- oder Mehrstufenverfahren an.

Die Polyaddition kann mit und ohne Katalysatoren durchgeführt werden. Geeignete Katalysatoren sind z.B. tertiäre Amine, wie etwa Triäthylendiamin; Metallsalze, wie z.B. Calciumacetat; oder organische Metallverbindungen, wie z.B. Dibutylzinndilaurat und Zinnoctoat. Diese Katalysatoren werden insbesondere in Mengen von 0,001 bis 0,5 Gew.%, bezogen auf das Polymere, zugesetzt.

Gemäss einer speziellen Ausführungsform der Erfindung werden in den photopolymerisierbaren Aufzeichnungsmaterialien als Komponente (B1) solche Polyurethane eingesetzt, die durch Umsetzung eines aliphatischen, gesättigten Polyesterglykols bzw. Polyetherglykols mit einem aliphatischen Diisocyanat, mindestens einem niedermolekularen aliphatischen Diol, zu 25 bis 100 Mol.% aus Buten-1-diol-3,4 oder Dimethylolnorbonen bestehend, sowie einer im Sinne der Isocyanatchemie bifunktionell reaktionsfähigen tertiären Stickstoff-Verbindung erhalten worden sind. Das aliphatische gesättigte Polyesterglykol bzw. Polyetherglykol ist eines der oben angegebenen Art und hat vorzugsweise ein Molekulargewicht von 400 bis 4000. Das aliphatische Diisocyanat ist insbesondere Hexamethylendiisocyanat und als tertiäre Stickstoffverbindung kommen vorzugsweise N-Methyl-diethanolamin oder N,N'-Bis(2-hydroxyethyl)-piperazin in Betracht. Das Buten-1-diol-3,4 oder Dimethylolnorbonen wird vorzugsweise zusammen mit Buten-2-diol-1,4, 2,3-Dichlor-buten-2-diol-1,4 und/oder gesättigten aliphatischen Diolen mit einem Molekulargewicht nicht über 200 verwendet, wie z.B. im Gemisch mit Ethylenglykol, Propylenglykol, Butandiol-1,3-Butandiol-1,4 oder Neopentylglykol. Die eingesetzten niedermolekularen aliphatischen Diole bestehen dabei vorzugsweise zu 50 bis 100 Mol.% aus Buten-1-diol-3,4 und/oder Dimethylolnorbonen.

Nach einer besonders bevorzugten Ausführungsform der Erfindung werden in den photopolymereisierbaren Aufzeichnungsmaterialien als Komponente (B1) solche Polyurethane eingesetzt, die durch Umsetzung von Diisocyanaten mit Polydiolen, im Sinne der Isocyanatchemie bifunktionell reaktionsfähigen tertiären Stickstoffverbindungen, Acryl- und/oder Methacrylsäureesterdiolen sowie gegebenenfalls weiteren niedermolekularen Diolen, Diaminen und/oder Aminoalkoholen als Kettenverlängerer hergestellt worden sind. Als Diisocanate kommen hierbei die weiter oben genannten, insbesondre die

aliphatischen und cycloaliphatischen Diisocyanate in Betracht, wobei Hexamethylendiisocyanat, Isophoron-diisocyanat und Dicyclohexylmethandiisocyanat unter anderem bevorzugt eingesetzt werden. Als Polydiol-Komponente werden in diesem Fall vorteilhaft die weiter oben genannten Polyetherdiole, insbesondere Polyethylenglykol, Polypropylenglykol, Ethylenoxid/Propylenoxid-Mischpolykondensationsprodukte und Polytetrahydrofuran, verwendet. Unter den im Sinne der Isocyanatchemie bifunktionell reaktionsfähigen tertiären Stickstoffverbindungen haben sich hier insbesondere die N-Alkyl-diethanolamine, wie N-Methyldiethanolamin und N-Ethyldiethanolamin; die N-Alkyldiisopropanolamine, wie z.B. das N-Methyldiisopropanolamin; als auch die Dihydroxyalenpiperazine, insbesondere das N,N'-Bis(2-hydroxyethyl)-piperazin, das N,N'-Bis-(2-hydroxylpropyl)piperazin, das N,N'-Bis(diethoxy)-piperazin, das N,N'-Bis(triethoxy)piperazin und das N,N'-Bis(triethoxy)piperazin und das N,N'-Bis(dipropoxy)piperazin; und Umsetzungsprodukte von sekundären Aminen mit Glycidol, wie z.B. das 1-(N,N-Diethyl)aminopropandiol-2,3, als vorteilhaft erwiesen. Von den Acryl- und/oder Methacrylsäureesterdiolen haben die der oben angegebenen allgemeinen Formel (IV) besondere Bedeutung, wobei wiederum diejenigen, in denen der Rest Q der allgemeinen Formel (V) entspricht, bevorzugt sind. Wie bereits weiter oben erwähnt, sind dabei die Umsetzungsprodukte aus Bisphenol-A-diglycidäther (z.B. ®Epikote 828 der Fa. Shell), 2,3-Epoxpropanol-1 (Glycidol) oder aliphatischen Diepoxyden, wie Butandioldiglycidylether, mit Acryl- und/oder Methacrylsäure besonders bevorzugt.

Die beschriebenen Polyurethane können, wie bereits erwähnt, vor ihrem Einsatz in den photopolymerisierbaren Aufzeichnungsmaterialien ganz oder teilweise quaternisiert werden. Sie können allein oder im Gemisch miteinander verwendet werden. Die photopolymerisierbare Schicht B der photopolymerisierbaren Aufzeichnungsmaterialien kann dabei in der Komponente (B1) neben den erfindungsgemäss einzusetzenden, vorgehend beschriebenen Polyurethanen auch noch weitere übliche polymere Bindemittel, die mit den in Rede stehenden Polyurethanen verträglich sind, enthalten. Als solche weiteren Bindemittel, die neben den erfindungsgemäss einzusetzenden Polyurethanen in der photopolymerisierbaren Schicht B enthalten sein können, kommen beispielsweise andere Polyurethane und gegebenenfalls modifizierte Polyvinylalkohole bzw. Vinylalkoholpolymerisate in Betracht. Der Anteil der erfindungsgemäss einzusetzenden Polyurethane soll 60 bis 100 Gew.%, bezogen auf das gesamte Bindemittel (Komponente B1), betragen. Bevorzugt werden die erfindungsgemäss einzusetzenden Polyurethane als einziges Bindemittel in der photopolymerisierbaren Schicht B der Aufzeichnungsmaterialien eingesetzt.

Die photopolymerisierbare Schicht B der Aufzeichnungsmaterialien enthält neben dem polymeren Bindemittel (Komponente B1) als weitere Bestandteile mindestens eine weitere photopolymerisierbare, ethylenisch ungesättigte Verbindung (Komponente B2), mindestens einen Photopolymerisationsinitiator (Komponente B3) sowie gegebenenfalls sonstige übliche Zusatzstoffe (Komponente B4).

Als weitere photopolymerisierbare, ethylenisch ungesättigte Verbindungen (Komponente B2) kommen die an sich bekannten niedermolekularen Monomeren und/oder Oligomeren (mit einem Molekulargewicht bis zu 5000, vorzugsweise mit einem Molekulargewicht bis zu 2000) in Frage, die für photopolymerisierbare Aufzeichnungsmaterialien der in Rede stehenden Art üblich und gebräuchlich sind. Die photopolymerisierbaren, ethylenisch ungesättigten Verbindungen (Komponente B2) sollen dabei – für den Fachmann selbstverständlich – mit dem polymeren Bindemittel (Komponente B1) verträglich sein und im allgemeinen einen Siedepunkt von über 100°C bei Atmosphärendruck aufweisen. Die photopolymerisierbaren, ethylenisch ungesättigten Verbindungen (Komponente B2) können monofunktionell oder mehrfunktionell sein, d.h. sie können eine oder mehrere der photoinitiierten Polymerisationsreaktion zugängliche C-C-Doppelbindungen besitzen. Die photopolymerisierbaren, ethylenisch ungesättigten Verbindungen (Komponente B2) können dabei alleine als auch in Mischung miteinander eingesetzt werden. Beispielsweise können ein oder mehrere monofunktionelle Verbindungen bzw. ein oder mehrere mehrfunktionelle Verbindungen dieser Art in dem photopolymerisierbaren Aufzeichnungsmaterial enthalten sein; in bestimmten Anwendungsfällen sind als Komponente (B2) Kombinationen von mono- und mehrfunktionellen, insbesondere Kombinationen von mono- und bifunktionellen photopolymerisierbaren, ethylenisch ungesättigten Verbindungen von Vorteil. Die Art als auch die Menge der eingesetzten photopolymerisierbaren, ethylenisch ungesättigten Verbindungen (Komponente B2) richtet sich natürlich nach dem mitverwendeten polymeren Bindemittel (Komponente B1) und insbesondere nach Art und Anwendungszweck des photopolymerisierbaren Aufzeichnungsmaterials, d.h. nach dessen angestrebtem Eigenschaftsbild. So sind beispielsweise für die Herstellung von Reliefdruckplatten im Hochdruck- und Akzidenz-Bereich mehrfunktionelle, schnell vernetzende photopolymerisierbare, ethylenisch ungesättigte Verbindungen als Komponente (B2) von Vorteil; für Aufzeichnungsmaterialien, die zur Herstellung von weichelastromeren Reliefdruckplatten verwendet werden sollen, sind als Komponente (B2) unter anderem Mischungen aus mono- und mehrfunktionellen photopolymerisierbaren Monomeren und/oder Oligomeren günstig.

Das Mengenverhältnis von polymerem Bindemittel (Komponente B1) zu den weiteren photopolymerisierbaren, ethylenisch ungesättigten Verbindungen (Komponente B2) in der photopolymerisierbaren Schicht B ist in weitem Umfang variierbar. Es beträgt im allgemeinen etwa 97 bis

40 Gew.-% an polymerem Bindemittel (Komponente B1) zu 3 bis 60 Gew.-% an photopolymerisierbaren, ethylenisch ungesättigten Verbindungen (Komponente B2). Vorzugsweise, insbesondere im Anwendungsbereich für die Herstellung von weichelastomeren Reliefdruckplatten, liegt das Verhältnis der Komponenten (B1) und (B2) in der photopolymerisierbaren Schicht B bei etwa 95 bis 60 Gew.-% an polymerem Bindemittel (Komponente B1) zu 5 bis 40 Gew.-% an photopolymerisierbaren, ethylenisch ungesättigten Verbindungen (Komponente B2), wobei diese Angaben jeweils auf die Summe der Komponenten (B1) und (B2) bezogen sind. Werden als Komponente (B2) Mischungen aus monofunktionellen und mehrfunktionellen photopolymerisierbaren, ethylenisch ungesättigten Verbindungen eingesetzt, so liegt der Anteil der monofunktionellen photopolymerisierbaren, ethylenisch ungesättigten Verbindungen hierin im allgemeinen im Bereich von 5 bis 50 Gew.-%, insebesondere von 5 bis 30 Gew.-% bezogen auf die Komponente (B2)

Geeignete photopolymerisierbare, ethylenisch ungesättigte Verbindungen, die als Komponente (B2) in den erfindungsgemässen photopolymerisierbaren Aufzeichnungsmaterialien eingesetzt werden können, sind unter anderem beispielsweise in den US-Patentschriften 2,760,863 und 3,060,203 beschrieben. So eignen sich Allylester von Carbonsäuren, wie Allylacrylat oder Diallylphthalat; Vinylester aliphatischer Monocarbonsäuren, wie z.B. Vinylacetat, Vinylbutyrat oder Vinyloleat; Vinylether von Alkoholen, wie Octadecylvinylether oder Butandiol-1,4-divinylether. Vorteilhaft sind Derivate, z.B. Ester oder Amide, von ungesättigten Carbonsäuren, wie beispielsweise Derivate von Maleinsäure und insbesondere Derivate der Acryl- oder Methacrylsäure. Als Beispiel für Maleinsäure-Derivate seien die Maleinsäuredialkylester mit 1 bis 4 Kohlenstoffatomen in der Alkohol-Komponente genannt. Besonders bevorzugt sind die monofunktionellen und mehrfunktionellen Derivate der Acrylsäure und Methacrylsäure. Hierzu gehören unter anderem neben Acrylsäure und Methacrylsäure selber Acrylamid und Methacrylamid, die N-Hydroxyalkyl(meth)acrylamide mit 1 bis 6 Kohlenstoff-Atomen in der Alkyl-Gruppe, wie z.B. N-Hydroxymethyl-(meth)-acrylamid oder N-Hydroxyethyl-(meth)-acrylamid; Derivate und Umsetzungsprodukte dieser (Meth)-Acrylamide sowie insbesondere die Ester der Acrylsäure und Methacrylsäure von Monoalkoholen, Dialkoholen oder Polyalkoholen. Als Vertreter der Acrylate und Methacrylate seien im einzelnen genannt: (Meth)-Acrylate von Alkanolen mit 1 bis 6 Kohlenstoff-Atomen, z.B. Methyl-(meth)-acrylat, Ethyl-(meth)-acrylat, Propyl-(meth)-acrylat, Butyl-(meth)-acrylat, Hexylmethacrylat; die Di- und Polyacrylate und -methacrylate, wie sie durch Veresterung von Diolen oder Polyolen mit Acrylsäure oder Methacrylsäure hergestellt werden können, wie z.B. die Di- bzw. Tri-(meth)-acrylate von Ethylenglykol, Diethylenglykol, Triethylenglykol, Polyethylenglykol mit einem Molekulargewicht bis etwa 500, 1,2-Propandiol, 1,3-Propandiol, Neopentylglykol(2,2-Dimethyl-propandiol), 1,4-Butandiol, 1,1,1-Trimethylolpropan, Glycerin oder Pentaerythrit; ferner die Monoacrylate und Monomethacrylate solcher Diole und Polyole, wie z.B. die Monoacrylate und Monomethacrylate des Ethylenglykols, des Di-, Tri- oder Tetraethylenglykols. Besonders günstig sind wegen ihrer Verträglichkeit mit den polymeren Bindemitteln (Komponente B1) sowie wegen ihrer elastizitätsverbessernden Eigenschaften insbesondere für den Flexodruck-Anwendungsbereich niedermolekulare, präpolymere Urethanacrylate, wie sie z.B. durch Umsetzung von Hydroxylalkyl-(meth)acrylaten [z.B. β-Hydroxyethyl-(meth)acrylat, β-Hydroxypropyl-(meth)acrylat], aliphatischen Diolen (z.B. der vorstehend genannten Art) und organischen Diisocyanaten (z.B. Hexamethylendiisocyanat oder Isophorondiisocyanat) hergestellt werden können. Solche niedermolekulare, präpolymere Urethanacrylate, die vorzugsweise ein Molekulargewicht unter 5000, insbesondere zwischen 500 und 3000 besitzen, sind beispielsweise in der DE-OS 16 44 797 beschrieben. Für die Herstellung von Aufzeichnungsmaterialien, die in Waser oder wässrigen Medien entwickelbar sein sollen, eignen sich neben den niedermolekularen, präpolymeren Urethanacrylaten besonders wasserslösliche Monomere, wie z.B. Hydroxyethyl(meth)acrylat und die Mono- und Di(meth)acrylate von Polyethylenglykolen mit einem Molekulargewicht von etwa 200 bis 500.

Als Photopolymerisationsinitiatoren (Komponente B3) kommen die bekannten und üblichen Verbindungen und Systeme für die Auslösung einer Photopolymerisationsreaktion bei Bestrahlung mit aktinischem Licht in Frage, wie sie hinreichend in der einschlägigen Fachliteratur beschrieben sind. Dabei werden solche Initiatoren bevorzugt, die unterhalb von 120°C, vorzugsweise unterhalb von 185°C thermisch inaktiv sind. Sie sollten in der photopolymerisierbaren Schicht B in dem Masse dispergierbar sein, welches zur Auslösung der gewünschten Polymerisation oder Vernetzung unter dem Einfluss der aktinischen Strahlung notwendig ist.

Genannt seien als Photoinitiatoren z.B. Acyloine und deren Derivate, wie Benzoin, Benzoinalkylether, α-Methylolbenzoin und dessen Ether, α-Methylbenzoin; vicinale Diketone und deren Derivate, wie z.B. Diacetyl, Benzil, Benzilketale, wie Benzildimethylketal, Benzilmethylethylketal, Benzilmethylbenzylketal, Benzilmethylallylketal oder Benzilethylenglykol-Monoketal; unsubstituierte und substituierte Chinone, wie Anthrachinon, Benzanthrachinon; Benzophenon und 4,4'-Bis-(dimethylamino)-benzophenon; und insbesondere Acylphosphinoxid-Verbindungen des Typs, wie sie z.B. in der DE-A-29 09 992 beschrieben sind.

Die Photopolymerisationsinitiatoren können alleine oder im Gemisch miteinander verwendet werden. Die Photoinitiatoren werden dabei in für die Initiierung der Photopolymerisation wirksamen Mengen eingesetzt. Je nach Extinktionskoeffizient des Initiators, Schichtdicke des Aufzeichnungsmaterials etc. beträgt die Menge des eingesetzten Photopolymerisationsinitiators im allgemeinen 0,02 bis 5 Gew.-% vorzugsweise 0,1 bis 3 Gew.-%, bezogen auf die Summe aller Komponenten der photopolymerisierbaren Schicht B. Die Photopolymerisationsinitiatoren können auch in Verbindung mit anderen Coinitiatoren oder Aktivatoren verwendet werden. So können beispielsweise Initiator-Systeme aus Benzoinmethylether und Triphenylphosphin; 4,4′-Bis-(dimethylamino)-benzophenon und einem halogenierten Kohlenwasserstoff (vgl. DE-A-27 59 164) oder den Acylphosphinoxid-Verbindungen und tertiären Aminen wie Methyldiethanolamin, Dimethylethanolamin oder Triethanolamin (vgl. DE-A-29 09 992) verwendet werden. Für solche Initiator-Systeme liegt die Gesamtkonzentration (Photoinitiator + Aktivator) bei 0,05 bis 8 Gew.-% vorzugsweise 0,5 bis 5 Gew.-%, bezogen auf die photopolymerisierbare Schicht B.

Neben dem polymeren Bindemittel (Komponente B1), den weiteren photopolymerisierbaren, ethylenisch ungesättigten Verbindungen (Komponente B2) sowie den Photopolymerisationsinitiatoren (Komponente B3) können in der photopolymerisierbaren Schicht B der erfindungsgemässen Aufzeichnungsmaterialien als zusätzliche Komponente (B4) gegebenenfalls noch die üblichen Zusatzstoffe in üblichen Mengen enthalten sein. Hierzu gehören insbesondere thermische Polymerisationsinhibitoren, anorganische oder organische Pigmente oder Farbstoffe, anorganische oder organische Füllstoffe, Weichmacher, Mattierungs- oder Gleitmittel, etc.

Geeignete Polymerisationsinhibitoren sind die üblichen zur Verhinderung einer thermischen Polymerisation verwendeten Verbindungen, beispielsweise Hydrochinon, p-Methoxyphenol, p-Chinon, Kupfer-I-chlorid, Methylenblau, β-Naphthol, Phenole, m-Dinitrobenzol, N-Nitrosoamine wie N-Nitrosodiphenylamin, Phenothiazine, Phosphorigsäureester wie Triphenylphosphit, oder die Salze, beispielsweise die Kalium- oder Aluminium-Salze, des N-Nitroso-cyclohexylhydroxylamins. Voraussetzung für die Auswahl derartiger Inhibitoren ist das Fehlen einer nennenswerten Eigenabsorption in dem aktinischen Bereich, in dem der gleichzeitig verwendete Photoinitiator absorbiert. Die Polymerisationsinhibitoren werden im allgemeinen in Mengen von 0,001 bis 2,0 Gew.-%, vorzugsweise in Mengen von 0,005 bis 0,5 Gew.-%, bezogen auf die Summe aller Kompenenten der photopolymerisierbaren Schicht B, eingesetzt. Zur Steuerung der Belichtungseigenschaften der erfindungsgemässen Aufzeichnungsmaterialien können in der photopolymerisierbaren Schicht B ferner Farbstoffe oder potochrome Zusätze enthalten sein. Der Zusatz von Farbstoffen oder Pigmenten kann auch der Identifizierung oder ästhetischen Zwecken dienen, vorausgesetzt, dass die Farbstoffe die aktinische Strahlung nicht stark absorbieren und die Photopolymerisationsreaktion nicht stören.

Die photopolymerisierbare Schicht B kann darüberhinaus gegebenenfalls auch noch weitere Zusätze, wie z.B. verträgliche Weichmacher, Wachse, gesättigte niedermolekulare Verbindungen mit Amidgruppen etc., enthalten, mit deren Hilfe bestimmte, vom jeweiligen Anwendungsgebiet abhängige, spezielle Eigenschaften eingestellt und verbessert werden können. Beispielsweise ergibt ein Zusatz von Weichmachern in der photopolymerisierbaren Schicht B in bestimmten Mengen weichelastische Schichten mit gutem Rückstellverhalten, so dass sich der Zusatz von Weichmachern insbesondere bei photopolymerisierbaren Aufzeichnungsmaterialien empfiehlt, die beispielsweise für die Herstellung von weichelastischen Reliefdruck-Platten eingesetzt werden sollen. Durch Zusatz von anderen Stoffen, wie z.B. bestimmten Polymeren oder Füllstoffen, kann entsprechend die Härte der belichteten Schichten erhöht werden. Als Weichmacher kommen die hierfür bekannten Verbindungen in Betracht, wie beispielsweise Phthalsäureester, Paraffinöle oder flüssige Polybutadien-Verbindungen. Weichmacher können in der photopolymerisierbaren Schicht B im allgemeinen in Mengen von 5 bis 30 Gew.-%, bezogen auf die Summe aller Komponenten der photopolymerisierbaren Schicht B, enthalten sein.

Die Beständigkeit der photopolymerisierbaren Aufzeichnungsmaterialien gegenüber Sauerstoff und Ozon kann – falls notwendig – verbessert werden, indem der photopolymerisierbaren Schicht B verträgliche bekannte Antioxidantien und/oder Ozonschutzmittel in geeigneter Menge zugesetzt werden.

Als Schichtträger A für die erfindungsgemässen photopolymerisierbaren Aufzeichnungsmaterialien eignen sich die an sich bekannten und üblichen Trägermateralien eignen sich die an sich bekannten und üblichen Trägermaterialien mit hinreichend hoher Dimensionsstabilität. Hierzu gehören Metallplatten oder -folien, beispielsweise aus Stahlblech, Aluminiumblech, Kupfer oder dgl., sowie Folien aus Hochpolymeren, wie z.B. Folien aus Polyethylenterephthalat, Polybutylenterephthalat, Polyamid oder Polycarbonat. Die Auswahl der Schichtträger A ist dabei nicht auf Platten oder Folien begrenzt, ebenso können Gewebe oder Vliese, wie Glasfasergewebe, als Trägermaterialien dienen. Die Auswahl des geeigneten Trägermaterials für den Schichtträger A hängt insbesondere von dem Anwendungszweck des photopolymerisierbaren Aufzeichnungsmaterials ab. So werden für die Herstellung beispielsweise von Photoresists vorzugsweise solche Trägermaterialien verwendet, die insbesondere leicht ätzbar oder galvanisierbar sind. Für die Herstellung von weichelastomeren Reliefdruck-Platten werden als Schichtträger flexible Materialien mit ausreichend hohem Elastizitätsmodul herangezogen. Neben der direkten Verankerung der photopolymerisierbaren Schicht B auf einem Schichtträger A hoher Festigkeit und Dimensionsstabilität können zur Erzielung höherer Plattendicken, wie sie beim Flexodruck in der Praxis durch die Benutzung konventioneller Gummiklischees vorgegeben sind, als Unterschicht für die photopolymerisierbare Schicht B andere weichelastische Trägermaterialien eingesetzt werden, die ihrerseits mit einem dimensionsstabilen Schichtträger haftfest verbunden sind. Beispielsweise können für Mehrschichtverbundplatten weichelastische Unterschichten eingesetzt werden, wie sie in der DE-A-24 44 118 beschrieben sind.

Die Herstellung der erfindungsgemässen photopolymerisierbaren Aufzeichnungsmaterialien erfolgt in an sich bekannter Weise durch Herstellen und Verbinden der einzelnen Schichten. Zur Herstellung der photopolymerisierbaren Schicht B werden die einzelnen Komponenten (B1), (B2), (B3) sowie gegebenenfalls (B4) nach bekannten Verfahren homogen miteinander vermischt und zu Schichten gewünschter Schichtdicke verarbeitet. Die homogenen, im wesentlichen nicht lichtstreuenden Gemische aus den einzelnen Komponenten der Schicht B können nach üblichen Knet- Misch- und Lösungsverfahren hergestellt werden. Die photopolymerisierbaren Schichten B können dann beispielsweise aus Lösungen der Gemische in geeigneten Lösungsmitteln (beispielsweise Tetrahydrofuran) durch Giessen auf die entsprechenden Schichtträger erzeugt werden. Ebenso können die photopolymerisierbaren Schichten B durch Pressen, Kalandrieren oder Extrudieren der Gemische hergestellt werden, wobei bei geeigneter Wahl der Inhibitoren keine thermische Anpolymerisation zu befürchten ist.

Die Gemische der Komponenten der Schicht B sowie die daraus hergestellten photopolymerisierbaren Schichten zeichnen sich aufgrund der erfindungsgemäss einzusetzenden Polyurethane (Komponente B1) durch eine leichte Handhabbarkeit und sehr gute Verarbeitbarkeit aus.

Zur Herstellung der photopolymerisierbaren Aufzeichnungsmaterialien können entweder vorgefertigte photopolymerisierbare Schichten B auf den Schichtträger A auflaminiert oder aufgepresst werden, oder es kann, wie erwähnt, ein Gemisch der Komponenten, die die photopolymerisierbare Schicht B bilden, in geeigneter Weise, beispielsweise durch Giessen aus einer Lösung, auf den Schichtträger A aufgebracht und hier zu der photopolymerisierbaren Schicht B mit der gewünschten Schichtstärke geformt werden.

In Abhängigkeit von den eingesetzten Materialien kann es dabei zweckmässig und notwendig sein, die photopolymerisierbare Schicht B auf dem Schichtträger A mittels einer Haftschicht fest zu verankern. Diese Haftschicht kann als Zwischenlack in einer Schichtdicke von etwa 0,5 bis 40 µm verwendet werden. Als Haftschichten können handelsübliche Ein- oder Zweikomponentenkleber verwendet werden, deren Art sich nach dem Schichtträgermaterial und nach den aufgebrachten Materialien der photopolymerisierbaren Schicht B richtet. Als häufig geeigneter Kleber seien die handelsüblichen Reaktionskleber auf Polyurethan- und auf Polychloropren-Basis genannt, die durch Substrieren oder Giessen in geeigneter Schichtdicke auf die zu verbindenden Schichten aufgebracht werden können.

Es ist oft von Vorteil, wenn bei den photopolymerisierbaren Aufzeichnungsmaterialien auf der dem Schichtträger abgewandten Oberfläche der photopolymerisierbaren Schicht B noch eine haftfest verbundene, dünne, klebfreie Deckschicht C aufgebracht ist. Eine solche haftfest verbundene Deckschicht C besteht bevorzugt aus einem harte, klebfreie, transparente und reissfeste Filme bildenden Polymeren. Da die Belichtung des photopolymerisierbaren Aufzeichnungsmaterials in diesen Fällen durch die Deckschicht C hindurch erfolgt und die Schicht C erst beim anschliessenden Entwickeln durch Abwaschen mit dem Entwickler-Lösungsmittel entfernt wird, soll die Deckschicht C aus solchen Polymeren bestehen, die im Entwickler-Lösungsmittel löslich sind. Da die photopolymerisierbare Schicht B der erfindungsgemässen Aufzeichnungsmaterialien nach der Belichtung vorteilhaft mit Wasser oder wässrigen Medien ausgewaschen wird, soll die Deckschicht C, deren Stärke je nach Anwendungsbereich der Aufzeichnungsmaterialien im allgemeinen zwischen etwa 0,1 bis 20 µm, zweckmässigerweise zwischen etwa 0,5 bis 5 µm liegt, ebenfalls hierin löslich sein. Als Beispiele für Polymere, die für die Herstellung der Deckschicht C in Betracht kommen, seien genannt: lösliche Polyamide und Copolyamide, Polyurethane, Polyvinylalkohol oder dessen Partialester, -ether oder -acetale, Gelatine, Polyvinylpyrrolidone, Polyethylenoxide mit Molekulargewichten über 100 000 und andere. Durch die haftfest verbundene Deckschicht C ist z.B. eine klebfreie, blasenfreie Negativauflage bei der Belichtung möglich; ferner wird der Zutritt von die Photopolymerisation inhibierendem Sauerstoff zu der photopolymerisierbaren Schicht B verhindert.

Es ist ferner oft vorteilhaft, die photopolymerisierbaren Aufzeichnungsmaterialien mit einer abziehbaren Deckfolie zu versehen, wobei diese direkt auf die photopolymerisierbare Schicht B aufgebracht sein oder zusammen mit der oben erwähnten haftfest verbundenen Deckschicht C verwendet werden kann. Die Deckfolie, die beispielsweise aus Polyamid oder einem Polyester, wie Polyethylenterephthalat oder Polybutylenterephthalat bestehen kann, und die vorteilhafterweise eine Schichtstärke im Bereich von etwa 20 bis 150 µm besitzt, wird im allgemeinen vor der bildmässigen Belichtung der Aufzeichnungsmaterialien abgezogen; bei hinreichender Transparenz der Deckschicht kann die Belichtung jedoch auch durch diese hindurch erfolgen wobei die Deckschicht dann vor der Entwicklung abgezogen wird.

Die photopolymerisierbaren Aufzeichnungsmaterialien zeichnen sich aufgrund der erfindungsgemäss einzusetzenden speziellen Polyurethan-Bindemittel (Komponente B1) neben der leichten Verarbeitbarkeit durch eine gute Handhabbarkeit aus. Sie haben im Vergleich zu bekannten Matrialien dieser Art eine herabgesetzte Haut- und Kontaktgiftigkeit; sie sind vergleichsweise thermostabil und auch über längere Zeiträume gut lagerfähig, ohne dass nachteilige Veränderungen, wie z.B. durch Alterung, Versprödung oder Kaltfluss, in Kauf genommen werden müssen. Die photopolymerisierbaren Aufzeichnungsmaterialien der Erfindung besitzen sehr gute Belichtungseigenschaften, d.h. sie sind leicht und schnell vernetzbar, obwohl sie im Vergleich zu anderen Materialien dieser Art einen geringeren Anteil an photopolymerisierbaren Monomeren oder Oligomeren (Komponente B2) enthalten, und sie besitzen einen positiven Belichtungsspielraum. Wegen der guten mechanischen Eigenschaften der in der Komponente (B1) erfindungsgemäss einzusetzenden Polyurethane lassen sich mit den erfindungsgemässen photopolymerisierbaren Aufzeichnungsmaterialien leicht Druckplatten mit dem jeweils gewünschten Eigenschaftsniveau herstellen, ohne dass hierbei andere Nachteile in Kauf genommen werden müssen. So lassen sich beispielsweise leicht photopolymerisierbare Aufzeichnungsmaterialien herstellen, deren Schicht B nach der Belichtung eine Shore A-Härte (DIN 53 505) von 50 bis 95 besitzt, wie es beispielsweise für die Herstellung von weichelastomeren Reliefdruckplaten erstrebenswert ist.

Die photopolymerisierbaren Aufzeichnungsmaterialien der Erfindung eignen sich insbesondere zur photochemischen Informationsfixierung durch bildmässiges Belichten der photopolymerisierbaren Schicht B und anschliessendes Entfernen der unbelichteten, unvernetzten Schichtanteile, insbesondere durch Auswaschen mit einem Entwicklerlösungsmittel in an sich bekannter Weise. Die Schichtstärke der photopolymerisierbaren Schicht B und der spezielle Aufbau der photopolymerisierbaren Aufzeichnungsmaterialien richten sich dabei nach dem speziellen Anwendungszweck. Während die Schichtstärke der photopolymerisierbaren Schicht B im allgemeinen leicht zwischen 0,005 und 6,5 mm Dicke variiert werden kann, werden beispielsweise bei der Herstellung von Photoresists Schichtdicken von 10 bis 50 µm verwendet. Für die Herstellung von Reliefdruckplaten beträgt die Schichtstärke der photopolymerisierbaren Schicht B im allgemeinen von einigen 100 µm bis zu einigen mm Dicke. Zur Herstellung von Druckplatten mit reliefbildenden Schichten von 3,0 mm bis 6,5 mm kann beispielsweise die photopolymerisierbare Schicht B auch aus Einzelschichten von photopolymerisierbaren Gemischen gegebenenfalls unter Verwendung von anlösenden Lösungsmitteln zusammenlaminiert werden. Dabei können zur Erzielung besonderer Druckeigenschaften Schichten unterschiedlicher Härte und Rezeptur verwendet werden. Zur Herstellung von Reliefplatten für den Flexodruckbereich können auch Aufzeichnungsmaterialien mit einem Mehrschichtenverbund entsprechend der DE-A-24 44 118 vorteilhaft sein, die eine elastomere, weichelastische Unterschicht sowie eine weitere Stabilisierungsschicht besitzen.

Die Belichtung der photopolymerisierbaren Aufzeichnungsmaterialien kann in Form einer Flach- oder Rundbelichtung erfolgen. Als Strahlungsquellen für das die Photopolymerisation bzw. Photovernetzung auslösende Licht können die handelsüblichen Lichtquellen von aktinischem Licht verwendet werden, wie beispielsweise UV-Fluoreszenzröhren, Quecksilbermitteldruckstrahler, aber auch Quecksilberhoch- oder -niederdruckstrahler, sowie superaktinische Leuchtstoffröhren, Xenon-Impulslampen, Metalliodid-dodierte Lampen, Kohlebogenlampen etc. Die Strahlungsquellen sollen ein Licht einer Wellenlänge zwischen 230 und 450 nm aussenden. Die emittierte Wellenlänge sollte bevorzugt bei 300 bis 420 nm liegen bzw. auf die Eigenabsorption des in der photopolymerisierbaren Schicht B enthaltenen Photoinitiators abgestimmt sein.

Als Entwickler-Lösungsmittel für das Auswaschen der unbelichteten, unvernetzten Anteile der Schicht B nach der bildmässigen Belichtung der Aufzeichnungsmaterialien können organische Lösungsmittel, wie beispielsweise Ketone, Dimethylformamid, N-Methylpyrrolidon etc. eingesetzt werden. Vorzugsweise werden zur Entwicklung der Platten jedoch Wasser oder wässrige Medien verwendet. Unter wässrigen Medien sollen dabei ganz allgemein sowohl wässrige Lösungen verstanden werden, als auch Gemische von Wasser mit in Wasser löslichen organischen Lösungsmitteln, beispielsweise Alkoholen, Aceton etc., die nicht entflammbar und ohne besondere Schutzvorkehrungen handhabbar sind. Wässrige Lösungen können dabei beispielsweise Protonierungsmittel, wie beispielsweise Salzsäure, Schwefelsäure, Ameisensäure oder Essigsäure, enthalten, um die Auswaschgeschwindigkeit zu erhöhen, sofern das Polyurethan (Komponente B1) noch quaternisierbare Stickstoffatome enthält. Zu den Gemischen aus Wasser und organischen Lösungsmitteln, die unter den oben erläuterten Begriff «wässrige Medien» fallen, gehören beispielsweise Alkohol/Wasser-Gemische, die bis zu 90 Gew.% Alkohol enthalten. Als Alkohole kommen z.B. Methanol, Ethanol, Isopropanol u.a. in Betracht.

Nach dem Auswaschen mit dem Entwicklungs-Lösungsmittel werden die resultierenden Reliefformen, z.B. Reliefdruckformen oder Photoresists, in üblicher Weise, gegebenenfalls bei Temperaturen bis zu 120°C, getrocknet. In manchen Fällen ist es zweckmässig, die erhaltenen Reliefformen anschliessend nochmals mit aktinischem Licht nachzubelichten, um die Festigkeit der Formen bzw. Druckplatten zu erhöhen.

Die gemäss der Erfindung hergestellten Druckformen können für alle Arten von Druckverfahren verwendet werden. Besonders vorteilhaft lassen sich mit den erfindungsgemässen Aufzeichnungsmaterialien weichelastomere Druckformen herstellen, die für Anwendungsbereiche geeignet sind, bei denen eine elastische, nachgiebig druckende Fläche erforderlich ist. In diesen Fällen soll

daher die photopolymere, reliefbildende Schicht B nach der Belichtung eine Shore A-Härte (DIN 53 505) von 50 bis 95, vorzugsweise von 60 bis 90, und einen Elastizitätsmodul (DIN 53457) im Bereich von 5 bis 50 N/mm$^2$ besitzen.

Zur Herstellung von Photoresists mittels der erfindungsgemässen photopolymerisierbaren Aufzeichnungsmaterialien kann auch das Schichtübertragungsverfahren, wie es beispielsweise in der DE-B-15 22 515 und der DE-B-21 23 702 beschrieben wird, angewandt werden. Die Photoresists eignen sich in bekannter Weise zur galvanischen oder stromlosen Metallablagerung, zum Ätzen und für die Gravur, z.B. bei der Herstellung von gedruckten Schaltungen, integrierten Schaltkreisen, Siebdruckschablonen und anderem.

Ein unerwarteter grosser Vorteil der erfindungsgemässen Aufzeichnungsmaterialien liegt darin, dass sie neben ihren guten Eigenschaften im unbelichteten Zustand und bei der Belichtung auch im belichteten Zustand nach der Entwicklung ausgezeichnete Eigenschaften aufweisen. So können bei ihrer Verarbeitung zu Reliefdruckformen verbesserte Reliefstrukturen erhalten werden, was z.B. beim Druck zu einer deutlich verbesserten Wiedergabe von Negativschriften führt. Überraschend ist auch das hohe Auflösungsvermögen, welches eine exakte Tonwertübertragung ermöglicht. Aus den erfindungsgemässen Aufzeichnungsmaterialien hergestellte Reliefdruckplatten haben gute Farbaufnahme- und -abgabeeigenschaften und zeigen nur ein geringes Quellvermögen gegenüber den für die Druckfarben eingesetzten Lösungsmitteln. Neben ihren anderen vorteilhaften mechanischen Eigenschaften besitzen sie eine hohe Abriebfestigkeit, wodurch grosse Auflagenhöhen mit einer Druckplatte erreicht werden können. Die Druckplatten besitzen ebenfalls eine hohe Wiederverwendbarkeit.

Die folgenden Beispiele sollen die vorliegende Erfindung weiter erläutern. Die in den Beispielen genannten Teile und Prozente beziehen sich, soweit nicht anders angegeben, auf das Gewicht. Volumenteile verhalten sich zu Teilen wie Liter zu Kilogramm. Die angegebenen Viskositäten wurden unter den jeweils angegebenen Versuchsbedingungen bestimmt.

Die angegebenen K-Werte wurden 1%ig in Dimethylformamid gemessen. Die Shore A-Härte wurde ermittelt nach DIN 53 505. Der Elastizitätsmodul wurde nach DIN 53 457 bestimmt. Die Reissdehnung und Reisskraft wurden nach DIN 53 504 ermittelt. Die Erweichungspunkte wurden auf der Koflerbank bestimmt.

Synthesebeispiele zur Herstellung von erfindungsgemäss als Komponente (B1) einzusetzenden Polyurethanen:

Synthesebeispiel I

In 621 g Tetrahydrofuran werden 250 g Polytetrahydrofuran (Molekulargewicht 1000), 59,6 g Methyldiethanolamin, 27 g Butandiol-1,4 sowie 232,5 g 1,6-Hexamethylendiisocyanat und 128 g einer 70 %igen acetonischen Lösung des Umsetzungsproduktes von Bisphenol-A-diglycidylether (®Epikote 828 der Fa. Shell) mit Acrylsäure unter Rühren gelöst. Nach Zugabe von 0,25 g Dibutylzinndilaurat und 0,5 g Zinnoctoat wird solange bei 60°C gerührt, bis die Viskosität der Lösung auf 500 mPas angestiegen ist.

Durch Zutropfen einer 50 %igen Lösung von 3,3′-Dimethyl-4,4′-diaminodicyclohexylmethan in Tetrahydrofuran wird die Viskosität bis auf 3400 mPas erhöht. Das eventuell noch vorhandene Diisocyanat wird durch Zugabe von 100 g Methanol vernichtet. Die in dem erhaltenen Polyurethan eingebauten tertiären Stickstoffatome werden durch weitere Zugaben von 72 g Eisessig quaternisiert. Der Erweichungspunkt des Polyurethans beträgt 74°C.

Synthesebeispiel II

In 763 g Tetrahydrofuran werden 250 g Polyethylenoxid (Molekulargewicht 1000), 119 g Methyldiethanolamin, 27 g Butandiol-1,4 sowie 319 g Hexamethylendiisocyanat und 128 g einer 70 %igen Lösung des Diacrylats von Bisphenol-A-diglycidylether in Aceton unter Rühren gelöst. Nach Zugabe von 0,2 g Butylzinndilaurat und 0,5 g Zinnoctoat setzt eine sehr heftige Reaktion ein, in deren Verlauf sich die Lösung auf 75°C erhitzt. Man lässt auf 60°C abkühlen und rührt bei dieser Temperatur noch so lange, bis die Viskosität auf 1000 mPas angestiegen ist. Nun wird durch langsames Zutropfen einer 50 %igen Lösung von 3,3′-Dimethyl-4,4′-diaminodicyclohexyl-methan in Tetrahydrofuran die Viskosität auf 4000 mPas erhöht. Ist diese Viskosität erreicht, werden 100 g Methanol und 72 g Eisessig eingerührt. Man erhält eine klare Lösung mit einem Feststoffgehalt von ca. 50%. Das Polyurethan hat einen K-Wert von 47 sowie einen Erweichungspunkt von 70°C.

Synthesebeispiel III

In 1.371 g Tetrahydrofuran werden 1.000 g Polyethylenoxid (Molekulargewicht 4000), 59,6 g Methyldiethanolamin, 27 g Butandiol-1,4 sowie 235,2 g Hexamethylendiisocyanat und 128 g einer 70 %igen acetonischen Lösung des Diacrylats von Bisphenol-A-diglycidylether unter Rühren gelöst. Dann werden 0,25 g Dibutylzinndilaurat und 0,5 g Zinnoctoat zugegeben und solange bei 60°C gerührt, bis die Viskosität der Lösung auf 50 mPas angestiegen ist. Durch tropfenweise Zugabe einer 50 %igen Lösung von 3,3′-Dimethyl-4,4′-diaminodicyclohexyl-methan in Tetrahydrofuran wird die Viskosität auf 1200 mPas erhöht. Anschliessend werden die noch freien Isocyan-Gruppen durch Zugabe von 100g Methanol desaktiviert und die im erhaltenen Polyurethan eingebauten tertiären Stickstoffatome durch Zugabe von 72 g Eisessig quaternisiert. Die so erhaltene Polyurethan-Lösung hat einen Feststoffgehalt von etwa 50%. Das erhaltene Polyurethan besitzt einen K-Wert von 35, einen Erweichungspunkt von 67°C, eine Viskosität von 1200 mPas bei 58°C und ist in Wasser einwandfrei löslich.

Synthesebeispiel IV

In 579 g Tetrahydrofuran werden 250 g Polypropylenoxid (Molekulargewicht 1.000), 59,6 g Methyldiethanolamin, 27 g Butnadiol-1,4 sowie 218 g Hexamethylendiisocyanat und 64 g einer 70 %igen acetonischen Lösung des Diacrylats von Bisphenol-A-diglycidylether unter Rühren gelöst. Nach Zugabe von 0,10 g Dibutylzinndilaurat und 0,2 g Zinnoctoat wird auf 60°C erwärmt und solange bei dieser Temperatur gerührt, bis die Viskosität 1500 mPas beträgt. Durch Zutropfen einer 50 %igen Lösung von 3,3'-Di-methyl-4,4'-diaminodicyclohexyl-methan in Tetrahydrofuran wird die Viskosität auf 3000 mPas erhöht. Anschliessend werden 100 g Methanol und 72 g Eisessig eingerührt. Die erhaltene Polymerlösung hat einen Feststoffgehalt von ca. 50%. Das Polyurethan besitzt einen K-Wert von ca. 37 und einen Erweichungspunkt von 85°C.

Synthesebeispiel V

In 621 g Tetrahydrofuran werden 250 g Polypropylenoxid (Molekulargewicht 1000), 59,6 g Methyldiethanolamin, 27 g Butandiol-1,4 sowie 235,2 g Hexamethylendiisocyanat und 128 g einer 70-%igen acetonischen Lösung des Diacrylats von Bisphenol-A-diglycidylether unter Rühren gelöst. Nach Zugabe von 0,2 g Dibutylzinndilaurat und 0,2 g Zinnoctoat wird solange bei 60°C gerührt, bis die Viskosität 500 mPas beträgt. Durch Zutropfen einer 50 %igen Lösung von 3,3'-Dimethyl-4,4'-diaminodicyclohexylmethan in Tetrahydrofuran wird die Viskosität auf 3600 mPas erhöht. Anschliessend werden 100 g Methanol und 72 g Eisessig eingerührt. Die so erhaltene Lösung hat einen Feststoffgehalt von ca. 50%. Das erhaltene Polyurethan hat einen K-Wert von etwa 50 und einen Erweichungspunkt von 82°C.

Synthesebeispiel VI

250 g eines Polyethylenoxids mit einem Molekulargewicht von 1000, 87,5 g N,N'-Diethanolpiperazin, 124 g einer 71 %igen acetonischen Lösung des Diacrylats von Bisphenol-A-diglycidylether, 31,5 g Butandiol-1,4 und 235,2 g 1,6-Hexamethylendiisocyanat werden in 745 g Tetrahydrofuran gelöst und solange bei 60°C gerührt, bis die Viskosität auf 140 Pas gestiegen ist. Danach werden 673 g Methanol zugegeben. Man erhält ein bei Raumtemperatur geliertes Produkt mit einem K-Wert von ca. 45 und einem Erweichungspunkt von 88°C.

Beispiel 1

78,5 Teilen eines gemäss Synthesebeispiel I hergestellten Polyurethans werden zusammen mit 5 Teilen Laurylacrylat, 15 Teilen eines präpolymeren Urethandiacrylats (Zusammensetzung: 1 ÄG eines Polyesterdiols, 2 ÄG Isophorondiisocyanat, 1,3 ÄG Butandiolmonoacrylat), 1,2 Teilen α-Methylolbenzoinmethyläther, 0,02 Teilen Zaponechtschwarz RE (C.I. 12195, Solvent Black 34), 0,25 Teilen des Kaliumsalzes des N-Nitrosocyclohexyl-hydroxylamin und 0,025 Teilen des sek. Butylthioanthrachinons in Tetrahydrofuran bei 50°C unter Rühren zu einer ca. 50 %igen Lösung gelöst und in solcher Schichtstärke auf eine Polyesterfolie aufgegossen, dass nach einstündigem Trocknen bei 60°C eine Schicht mit 0,7 mm Dicke zurückbleibt. Die Polyesterfolie war zuvor mit einer ca. 2 µm dicken Schicht aus Polyamid beschichtet worden. Mit Hilfe dieser Beschichtung lässt sich die photopolymerisierbare Schicht wieder von der Polyesterfolie abheben, wobei die Polyamid-Schicht auf der photopolymerisierbaren Reliefschicht verbleibt. Zur Verankerung auf einer Trägerschicht wird eine Metallträgerplatte mit einem handelsüblichen Polyurethanlack beschichtet und auf die freie Seite der photopolymerisierbaren Reliefschicht aufgewalzt.

Nach Abheben der Polyesterfolie (Deckfolie) wird ein fotographisches Negativ aufgelegt und 8 Minuten in einem handelsüblichen Flachbelichter (40 Watt-UV-Fluoreszenzlampen) unter einer Vakuumfolie bildmässig belichtet. Anschliessend wird die belichtete Platte in einem Sprühwascher mit einem Ethanol/Wasser-Gemisch (9:1-Vol.Teile) ca. 4 Minuten ausgewaschen, wobei die unbelichteten Schichtanteile herausgelöst werden. Die erhaltene Reliefform wird anschliessend 30 Minuten bei 50°C getrocknet und 10 Minuten in dem gleichen Belichter ohne Abdeckung nachbelichtet. Die Reliefform, deren Reliefschicht eine Shore A-Härte von 75, eine Reissdehnung von 105% und eine Reissfestigkeit von 6,5 $N/mm^2$ besitzt, eignet sich ausgezeichnet als Druckplatte für Druckfarben auf Mineralölbasis. Die Drucke zeigen eine exakte Wiedergabe der Vorlage mit randscharfen Details. Die Elastizität der Druckform ist sehr gut.

Beispiel 2

Eine Reliefdruckform mit einer Reliefschichtdicke von 0,5 mm für ölfeste Flexodruckzwecke wird wie folgt hergestellt:

Auf eine 0,125 mm dicke Polyester-Trägerfolie, die mit einem in einer wässrigen Alkohol-Lösung löslichen Polyamid (ca. 2 µm) beschichtet ist, wird eine ca. 45 %ige Lösung (Lösungsmittel: Tetrahydrofuran) von 63,53 Teilen eines gemäss Synthesebeispiel II hergestellten Polyurethans, 15 Teilen eines präpolymeren Urethanacrylats (Zusammensetzung: 1 ÄG eines Polytetrahydrofurandiols, 2 ÄG Isophorondiisocyanat, 2 ÄG Butandiolmonoacrylat), 5 Teilen 1,1,1-Trimethylolpropan-triacrylat, 1,2 Teile Benzildimethylketal, 0,03 Teilen eines schwarzen Farbstoffes (C.I. 26150, Solvent Black 3), 0,25 Teilen des Aluminiumsalzes des N-Nitrosocylohexyl-hydroxylamins und 15 Teilen eines Polymerweichmachers aus Adipinsäure und Butandiol aufgerakelt und anschliessend 60 Minuten bei 60°C getrocknet. Die so erhaltene photopolymerisierbare Reliefschicht wird auf einer mit einem handelsüblichen Zweikomponenten-Polyurethanhaftkleber beschichteten Polyesterfolie aufgewalzt. Die unbelichtete Folienplatte wird von der Plattenrückseite her, d.h. durch die Trägerfolie hindurch, in dem Flachbelichter von Beispiel 1, 2 Sekunden vorbelichtet. Anschliessend wird die Polyester-Deckfolie von der Plattenoberseite abgezogen, ein fotographisches Negativ aufgelegt und die Platte 6 Minuten in dem Flachbelichter von Beispiel 1 belichtet. Nach 5-minütigem Auswaschen in einem handelsüblichen Bürstenwascher mit einem Entwicklerlösungsmittelgemisch aus Cyclohexanon/ Ethanol/Wasser (1:6:3 Vol.-Teile) und einstündigem Trocknen bei 60°C wird 10 Minuten nachbelichtet. Die Relief-Schicht besitzt hiernach eine Shore A-Härte von 68, eine Reissfestigkeit von 12 N/mm² und eine Reissdehnung von etwa 165%. Die erhaltene Reliefdruckplatte weist ein hohes Auflösevermögen und hohe Auflagenbeständigkeit auf.

Beispiel 3–6

Analog Beispiel 1 wurden weitere Aufzeichnungsmaterialien und daraus Reliefformen hergestellt, wobei die photopolymerisierbaren, reliefbildenden Schichten im einzelnen wie folgt zusammengesetzt waren:

Beispiel 3:

78,5 Teile eines gemäss Synthesebeispiel III hergestellten Polyurethans, 15 Teile 1,1,1-Trimethylolpropan-trimethacrylat; 5 Teile des Diacrylats von Bisphenol A-diglycidylether; 1,2 Teile Benzildimethylketal; 0,02 Teile Zaponechtschwarz RE (C. I. 12195, Solvent Black 34); 0,25 Teile des Kaliumsalzes des N-Nitrosocyclohexyl-hydroxylamins und 0,02 Teil m-Dinitrobenzol.

Beispiel 4:

63,5 Teile eines gemäss Synthesebeispiel IV hergestellten Polyurethans; 15 Teile eines niedermolekularen Urethanacrylates (Zusammensetzung: 1 ÄG Polypropylenglykol, 2 ÄG Isophorondiisocyanat, 1,3 ÄG Butandiolmonoacrylat); 1,2 Teile Benzildimethylketal; 0,02 Teile des schwarzen Farbstoffs von Beispiel 2; 0,25 Teile des Inhibitors von Beispiel 2; 0,025 Teile sek.-Butylthioanthrachinon und 20 Teile Dibutylphthalat.

Beispiel 5:

58,53 Teile eines gemäss Synthesebeispiel V hergestellten Polyurethans; 20 Teile eines niedermolekularen Urethanacrylates (Zusammensetzung: 1 ÄG eines Polycaprolactons, 2 ÄG Isophorondiisocyanat, 1,3 ÄG Butandiolmonoacrylat); 1,2 Teile Benzildimethylketal; 0,02 Teile des schwarzen Farbstoffs von Beispiel 1; 0,25 Teile des Inhibitors von Beispiel 1 und 20 Teile Dibutylphthalat.

Beispiel 6:

83,5 Teile eines gemäss Synthesebeispiel VI hergestellten Polyurethans; 10 Teile Pentaerythrittetraacrylat; 5 Teile Hexandioldimethacrylat; 1,2 Teile Benzildimethylketal; 0,03 Teile des schwarzen Farbstoffs von Beispiel 2; 0,25 Teile des Inhibitors von Beispiel 1; 0,02 Teile m-Dinitrobenzol.

Die so hergestellten Reliefformen eigneten sich allesamt ausgezeichnet als Druckplatten mit guter Resistenz gegenüber Druckfarben auf Mineralölbasis, gutem Druckverhalten, exakter Wiedergabe der Vorlage und hoher Abriebsfestigkeit.

**Patentansprüche**

1. Photopolymerisierbares Aufzeichnungsmaterial mit einem Schichtträger A, einer photopolymerisierbaren Schicht B sowie gegebenenfalls einer Deckschicht und/oder Deckfolie C, bei dem die photopolymerisierbare Schicht B enthält

1. als polymeres Bindemittel ein Polyurethan mit photopolymerisierbaren Doppelbindungen,
2. mindestens eine weitere photopolymerisierbare, ethylenisch ungesättigte Verbindung,
3. einen Photopolymerisationsinitiator sowie
4. gegebenenfalls sonstige übliche Zusatzstoffe,

dadurch gekennzeichnet, dass in der photopolymerisierbaren Schicht B als Bindemittel (Komponente B1) ein im wesentlichen lineares, bei Raumtemperatur festes, hochmolekulares, thermoplastisches Polyurethan enthalten ist, das seitenständige photopolymerisierbare Doppelbindungen und quaternäre und/oder quaternisierbare Stickstoffatome eingebaut enthält.

2. Photopolymerisierbares Aufzeichnungsmaterial gemäss Anspruch 1, dadurch gekennzeichnet, dass das Polyurethan der Komponente (B1) einen K-Wert im Bereich von etwa 25 bis 70, insbesondere von etwa 30 bis 60, besitzt.

3. Photopolymerisierbares Aufzeichnungsmaterial gemäss Ansprüchen 1 und 2, dadurch gekennzeichnet, dass das in der Komponente (B1) einzusetzende Polyurethan einen Erweichungspunkt über 35°C, insbesondere über 55°C besitzt.

4. Photopolymerisierbares Aufzeichnungsmaterial gemäss Ansprüchen 1 bis 3, dadurch gekennzeichnet, dass das in der Komponente (B1) einzusetzende Polyurethan einen Gehalt an seitenständigen photopolymerisierbaren Doppelbindungen von 0,01 bis 2,5 Gew.-%, insbesondere von 0,05 bis 2 Gew.-%, bezogen auf das Gewicht des Polyurethans, aufweist.

5. Photopolymerisierbares Aufzeichnungsmaterial gemäss Anspruch 4, dadurch gekennzeichnet, dass das in der Komponente (B1) einzusetzende Polyurethan seitenständige acrylische Doppelbindungen eingebaut enthält.

6. Photopolymerisierbares Aufzeichnungsmaterial gemäss Ansprüchen 1 bis 5, dadurch gekennzeichnet, dass das in der Komponente (B1) einzusetzende Polyurethan einen Gehalt an quaternären und/oder quaternisierbaren Stickstoffatomen von 0,2 bis 2,5 Gew.-%, insbesondere von 0,4 bis 1,8 Gew.-%, bezogen auf das Gewicht des Polyurethans, aufweist.

7. Photopolymerisierbares Aufzeichnungsmaterial gemäss Ansprüchen 1 bis 6, dadurch gekennzeichnet, dass das in der Komponente (B1) einzusetzende Polyurethan hergestellt worden ist durch Umsetzung von einem Diisocyanat mit

einem Polydiol, einer im Sinne der Isocyanatchemie bifunktionell reaktionsfähigen tertiären Stickstoff-Verbindung, einer kettenverlängernden, zwei im Sinne der Isocyanatchemie reaktionsfähige Wasserstoffatome tragenden Verbindungen mit seitenständigen olefinischen Doppelbindungen sowie gegebenenfalls weiteren niedermolekularen Kettenverlängerern.

8. Photopolymerisierbares Aufzeichnungsmaterial gemäss Anspruch 7, dadurch gekennzeichnet, dass das in der Komponente (B1) einzusetzende Polyurethan hergestellt worden ist durch Umsetzung der einzelnen Komponenten in einem solchen Verhältnis, dass das NCO/OH, NH-Molverhältnis etwa 0,8 bis 1,85, insbesondere etwa 0,9 bis 1,2, beträgt.

9. Verfahren zur Herstellung von Reliefformen durch bildmässiges Belichten der photopolymerisierbaren Schicht eines Aufzeichnungsmaterials mit aktinischem Licht, Auswaschen der unbelichteten, unvernetzten Bereiche der photopolymeren Schicht mit einem Entwicklerlösungsmittel und anschliessendes Trocknen sowie gegebenenfalls Nachbelichten der erhaltenen Reliefform, dadurch gekennzeichnet, dass ein photopolymerisierbares Aufzeichnungsmaterial gemäss einem der Ansprüche 1 bis 8 verwendet wird.

**Claims**

1. A photopolymerizable recording material comprising a base A and a photopolymerizable layer B with or without a top layer and/or cover sheet C, the photopolymerizable layer B containing

1. as the polymeric binder, a polyurethane having photopolymerizable double bonds,
2. at least one further photopolymerizable ethylenically unsaturated compound, and
3. a photopolymerization initiator, with or without
4. other conventional additives,

wherein the photopolymerizable layer B contains, as binder (component B1), a substantially linear, high molecular weight, thermoplastic polyurethane which is solid at room temperature and which possesses photopolymerizable double bonds in side branches, and also possesses quaternary and/or quaternizable nitrogen atoms.

2. A photopolymerizable recording material as claimed in claim 1, wherein the polyurethane used as component (B1) has a K value of from about 25 to 70, particularly from about 30 to 60.

3. A photopolymerizable recording material as claimed in claims 1 and 2, wherein the polyurethane used as component (B1) has a softening point above 35°C, particularly above 55°C.

4. A photopolymerizable recording material as claimed in claims 1 to 3, wherein the polyurethane used as component (B1) contains from 0.01 to 2.5% by weight, particularly from 0.05 to 2% by weight, based on the weight of polyurethane, of photopolymerizable double bonds in side branches.

5. A photopolymerizable recording material as claimed in claim 4, wherein the polyurethane used as component (B1) contains acrylic double bonds in side branches.

6. A photopolymerizable recording material as claimed in claims 1 to 5, wherein the polyurethane used as component (B1) contains from 0.2 to 2.5% by weight, particularly from 0.4 to 1.8% by weight, based on the weight of polyurethane, of quaternary and/or quaternizable nitrogen atoms.

7. A photopolymerizable recording material as claimed in claims 1 to 6, wherein the polyurethane used as component (B1) has been prepared by reacting a diisocyanate with a polydiol, a tertiary nitrogen compound which is bifunctionally reactive towards isocyanates, and a chain extender compound which has two hydrogen atoms which are reactive towards isocyanates and possesses olefinic double bonds in side branches, with or without other low molecular weight chain extenders.

8. A photopolymerizable recording material as claimed in claim 7, wherein the polyurethane used as component (B1) has been prepared by reacting the individual components in a ratio which corresponds to an NCO/OH + NH molar ratio of from about 0.8 to 1.85, particularly from about 0.9 to 1.2.

9. A process for the preparation of a relief plate by imagewise exposure of the photopolymerizable layer of a recording material with actinic light, washing out the unexposed, non-crosslinked areas of the photopolymerizable layer with a developer solution, and then drying and optionally post-exposing the resulting relief plate, wherein a photopolymerizable recording material as claimed in any of claims 1 to 8 is employed.

**Revendications**

1. Matériau d'enregistrement photopolymerisable comportant une couche support A, une couche photopolymérisable B ainsi qu'éventuellement une couche et/ou une feuille de protection C, la couche photopolymérisable B contenant

1. comme liant polymère, un polyuréthane à doubles liaisons photopolymérisables,
2. au moins un autre composé à insaturation éthylénique, photopolymérisable,
3. un initiateur de photopolymérisation, ainsi que
4. éventuellement différents additifs usuels

caractérisé par le fait que, dans la couche photopolymérisable B, est contenu, comme liant (composant B1), un polyuréthane essentiellement linéaire, solide à la température ambiante, de poids moléculaire élevé, et thermoplastique, qui contient, inclus, des doubles liaisons photopolymérisables latérales et des atomes d'azote quaternaires ou quaternisables.

2. Matériau d'enregistrement photopolymérisable selon la revendication 1, caractérisé par le fait que le polyuréthane du composant (B1) possède un indice K dans les limites d'environ 25 à 70, en particulier d'environ 30 à 60.

3. Matériau d'enregistrement photopolymérisable selon les revendications 1 et 2, caractérisé par le fait que le polyuréthane à introduire dans le composant (B1) possède un point de ramollissement supérieur à 35°C, en particulier supérieur à 55°C.

4. Matériau d'enregistrement photopolymérisable selon les revendications 1 à 3, caractérisé par le fait que le polyuréthane à introduire dans le composant (B1) présente une teneur en doubles liaisons photopolymérisables, latérales de 0,01 à 2,5% en poids, en particulier de 0,05 à 2% en poids, rapportée au poids du polyuréthane.

5. Matériau d'enregistrement photopolymérisable selon la revendication 4, caractérisé par le fait que le polyuréthane à introduire dans le composant (B1) contient, incluses, des doubles liaisons acryliques, latérales.

6. Matériau d'enregistrement photopolymérisable selon les revendications 1 à 5, caractérisé par le fait que le polyuréthane à introduire dans le composant (B1) a une teneur en atomes d'azote quaternaires et/ou quaternisables de 0,2 à 2,5% en poids, en particulier de 0,4 à 1,8% en poids, rapportée au poids du polyuréthane.

7. Matériau d'enregistrement photopolymérisable selon les revendications 1 à 6, caractérisé par le fait que le polyuréthane à introduire dans le composant (B1) a été préparé par réaction d'un diisocyanate avec un polydiol, un composé à azote tertiaire, réactif, bifonctionnel, dans le sens de la chimie de l'isocyanate, un composé à doubles liaisons oléfiniques, latérales, allongeant la chaîne et portant deux atomes d'hydrogène réactif, dans le sens de la chimie de l'isocyanate, et éventuellement aussi d'autres allongeurs de chaîne à faible poids moléculaire.

8. Matériau d'enregistrement photopolymérisable selon la revendication 7, caractérisé par le fait que le polyuréthane à introduire dans le composant (B1) a été préparé par réaction des différents composants en proportions telles que le rapport molaire NH, NCO/OH, soit d'environ 0,8 à 1,85, en particulier d'environ 0,9 à 1,2.

9. Procédé de préparation de formes en relief par exposition, pour produire une image, de la couche photopolymérisable d'un matériau d'enregistrement, avec une lumière actinique, élimination par lavage de la zone non exposée et non réticulée de la couche photopolymérisable, avec un solvant de développement puis séchage, ainsi qu'éventuellement post-exposition de la forme en relief obtenue, caractérisé par le fait qu'on utilise un matériau d'enregistrement photopolymérisable selon l'une des revendications 1 à 8.